# EUROPEAN PATENT SPECIFICATION

(11) **EP 4 124 937 B1**
(45) Date of publication and mention of the grant of the patent: **11.02.2026**
(21) Application number: 22184316.2
(22) Date of filing: 12.07.2022
(51) Int. Cl.: G06F 3/041, G06F 3/044

(54) **TRANSPARENT DISPLAY DEVICE**
TRANSPARENTE ANZEIGEVORRICHTUNG
DISPOSITIF D'AFFICHAGE TRANSPARENT

(30) Priority: 30.07.2021 KR 20210100908
(43) Date of publication of application: 01.02.2023
(73) Proprietor: LG Display Co., Ltd., SEOUL, 07336 (KR)
(72) Inventor: PARK, JaeHee, Gyeonggi-do 10845 (KR); IM, Jonghyeok, Gyeonggi-do 10845 (KR); LEE, MiReum, Gyeonggi-do 10845 (KR)
(74) Representative: Viering, Jentschura & Partner mbB Patent- und Rechtsanwälte

(56) References cited:
- US-A1- 2015 153 874
- US-A1- 2016 098 113
- US-A1- 2019 058 020

## Description

### BACKGROUND

### Field of the Invention

The present disclosure relates to a transparent display device.

### Description of the Related Art

With the advancement of the information age, the demand for a display device for displaying an image has increased in various forms. Therefore, various types of display devices such as a liquid crystal display (LCD) device, a plasma display panel (PDP) device, a quantum dot light emitting display (QLED) device and an organic light emitting display (OLED) device have been recently used.

Recently, studies for a transparent display device in which a user may view objects or images positioned at an opposite side by transmitting the display device are actively ongoing.

The transparent display device includes a display area on which an image is displayed, wherein the display area may include a transmissive area capable of transmitting external light and a non-transmissive area, and may have high light transmittance through the transmissive area.

The transparent display device may include a plurality of touch sensors and a plurality of touch lines to implement a touch function. However, the transparent display device has problems in that it is not easy to form the plurality of touch sensors and the plurality of touch lines or a process is complicated, and light transmittance may be reduced due to the plurality of touch sensors and the plurality of touch lines.

US2019/058020 A1 discloses a transparent touch display device that has a grid shaped conductive layer functioning as touch electrode layer laying in the non-transmissive areas of the device.

### SUMMARY

The present disclosure has been made in view of the above problems and it is an object of the present disclosure to provide a transparent display device that may minimize loss of light transmittance due to a touch sensor and a touch line.

It is another object of the present disclosure to provide a transparent display device that may simplify a touch process.

In addition to the objects of the present disclosure as mentioned above, additional objects and features of the present disclosure will be clearly understood by those skilled in the art from the following description of the present disclosure. In an aspect of the present disclosure, there is provided a transparent display device according to claim 1. Further embodiments are described in the dependent claims.

In accordance with an aspect of the present disclosure, the above and other objects can be accomplished by the provision of a transparent display device comprising a substrate provided with a plurality of transmissive areas and a non-transmissive area including a plurality of light emission areas disposed between the transmissive areas adjacent to each other, a plurality of light emitting elements provided in the plurality of light emission areas over the substrate, a plurality of touch sensors provided in the plurality of transmissive areas over the substrate, a plurality of touch lines provided in the non-transmissive area over the substrate and extended in a first direction, and a plurality of bridge lines provided in the non-transmissive area over the substrate and extended in a second direction to connect at least two touch sensors disposed in the second direction with one of the plurality of touch lines. Each light emitting element may be provided in a respective one of the plurality of light emission areas. Each touch sensor may be provided in a respective one of the plurality of transmissive areas.

The transparent display device may further comprise a first electrode provided in each of the light emission areas over the substrate; a light emitting layer provided over the first electrode; and a second electrode disposed over the light emitting layer, wherein the second electrode includes a cathode electrode provided in the non-transmissive area to constitute the light emitting elements in the non-transmissive area, and a touch sensor electrode provided in a transmissive area of the plurality of transmissive areas to constitute the touch sensor in the transmissive area.

The transparent display device may further comprise a first undercut structure disposed along an edge of the transmissive area, wherein the cathode electrode and the touch sensor electrode are spaced apart from each other by the first undercut structure.

The transparent display device may further comprise a plurality of inorganic insulating layers provided in the non-transmissive area over the substrate and made of an inorganic material; and a planarization layer provided in the non-transmissive area over the plurality of inorganic insulating layers and made of an organic material, wherein the first undercut structure is provided such that the planarization layer is more protruded toward the transmissive area than the plurality of inorganic insulating layers.

The transparent display device may further comprise a common power line provided in the non-transmissive area over the substrate and extended in the first direction; a cathode contact portion provided between the common power line and the transmissive area; and a power connection line connecting the cathode contact portion with the common power line, wherein the cathode electrode is electrically connected to the common power line through the cathode contact portion.

The transparent display device may further comprise a common power line provided in the non-transmissive area over the substrate and extended a second undercut structure that exposes at least a portion of the cathode contact portion, wherein the cathode electrode is directly in contact with the cathode contact portion exposed by the second undercut structure.

The transparent display device may further comprise a touch sensor contact portion (herein also referred to as touch contact portion) provided in the transmissive area; and a touch connection line connecting the touch sensor contact portion with a bridge line of the plurality of bridge lines, wherein the touch sensor electrode is electrically connected to a touch line of the plurality of touch lines through the touch sensor contact portion.

The transparent display device may further comprise a third undercut structure that exposes at least a portion of the touch contact portion, wherein the touch sensor electrode is directly in contact with the touch contact portion exposed by the third undercut structure.

One bridge line of the plurality of bridge lines may be connected to one of the plurality of touch lines, and may be connected to at least two touch connection lines connected to each of at least two touch sensors disposed in the second direction.

The transparent display device may further comprise a driving transistor provided between the substrate and the first electrode; and a light shielding layer provided between the substrate and the driving transistor, wherein the touch connection line is provided in the same layer as the light shielding layer.

The plurality of touch lines may be provided to at least partially overlap the plurality of light emission areas between the substrate and the first electrode.

The transparent display device may further comprise a plurality of touch blocks including a plurality of pixels provided in the non-transmissive area and the plurality of touch sensors provided in the plurality of transmissive areas; and a touch driver, wherein the plurality of touch lines have one end connected to the touch driver.

The number of touch lines provided over the substrate may be the same as the number of touch blocks provided over the substrate.

At least two touch lines may be disposed between the transmissive areas adjacent to each other, and one bridge line may be disposed between the adjacent transmissive areas.

The first undercut structure may have a planar closed shape.

The touch sensor contact portion may be provided in the closed shape of the first undercut structure to contact the touch sensor electrode.

In accordance with another aspect of the present disclosure, the above and other objects can be accomplished by the provision of a transparent display device comprising a substrate provided with a display area including a plurality of transmissive areas and a non-transmissive area disposed between the transmissive areas adjacent to each other, and a non-display area, a plurality of touch blocks including a plurality of pixels provided in the non-transmissive area and a plurality of touch sensors provided in the plurality of transmissive areas, a plurality of touch lines provided over the substrate, having one end connected to a touch driver and extended in the display area in a first direction, and a plurality of bridge lines provided over the substrate, having one end connected to any one of the plurality of touch lines, extended in the display area in a second direction and connected to at least two touch sensors disposed in the second direction. Each touch sensor may be provided in a respective one of the plurality of transmissive areas.

The number of touch lines provided over the substrate may be the same as the number of touch blocks provided over the substrate.

At least two touch lines may be disposed between the transmissive areas adjacent to each other, and one bridge line may be disposed between the adjacent transmissive areas.

One bridge line may be connected to one of the plurality of touch lines, and may be connected to at least two touch sensors disposed in the second direction.

Each of the plurality of pixels may include an anode electrode, a light emitting layer and a cathode electrode. Each of the plurality of touch sensors may include a touch sensor electrode. A cathode electrode of the pixel and the touch sensor electrode of the touch sensor may be formed of the same material in the same layer.

The touch sensor electrode may be disposed in the transmissive area, and the cathode electrode may be disposed in an area except an area in which the touch sensor electrode is disposed, and the touch sensor electrode and the cathode electrode may be spaced apart from each other.

The transparent display device may further comprise a first undercut structure provided in the transmissive area, having a planar closed shape, wherein the touch sensor electrode and the cathode electrode are separated from each other by the first undercut structure.

The transparent display device may further comprise a common power line provided in the non-transmissive area over the substrate and extended in the first direction; a cathode contact portion provided between the common power line and the first undercut structure to contact the cathode electrode; and a power connection line connecting the cathode contact portion with the common power line.

The transparent display device may further comprise a touch sensor contact portion (herein also referred to as touch contact portion) provided in the closed shape of the first undercut structure to contact the touch sensor electrode; and a touch connection line connecting the touch sensor contact portion with the bridge line.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a schematic plane view illustrating a transparent display panel;
FIG. 2 is a schematic view illustrating an example of a pixel provided in an area A of FIG. 1;
FIG. 3 is a view illustrating an example of signal lines, touch lines and a touch sensor, which are provided in an area B of FIG. 2;
FIG. 4 is a view illustrating a connection relation between a plurality of touch blocks and a plurality of touch lines;
FIG. 5 is a view illustrating a connection relation between a plurality of touch blocks and a plurality of touch sensors in one touch block;
FIG. 6 is a cross-sectional view taken along line I-I' of FIG. 3;
FIG. 7 is a cross-sectional view taken along line II-II' of FIG. 3;
FIG. 8A is a cross-sectional view taken along line III-III' of FIG. 3;
FIG. 8B is a cross-sectional view illustrating a modified example of FIG. 8A;
FIG. 8C is a cross-sectional view illustrating another modified example of FIG. 8A;
FIG. 9 is a view illustrating an example that a cathode electrode, a touch sensor electrode, a first undercut structure, a second undercut structure and a third undercut structure are disposed;
FIG. 10 is a view illustrating another undercut structure for comparison with the first undercut structure shown in FIG. 6;
FIG. 11 is a view illustrating other undercut structure for comparison with the first undercut structure shown in FIG. 6;
FIG. 12 is a view illustrating a modified example of FIG. 3; and
FIG. 13 is a cross-sectional view taken along line IV-IV' of FIG. 12.

### DETAILED DESCRIPTION OF THE DISCLOSURE

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing embodiments of the present disclosure are merely an example, and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description will be omitted. In a case where 'comprise', 'have', and 'include' described in the present specification are used, another part may be added unless 'only~' is used. The terms of a singular form may include plural forms unless referred to the contrary.

In construing an element, the element is construed as including an error range although there is no explicit description.

In describing a position relationship, for example, when the position relationship is described as 'upon~', 'above~', 'below~', and 'next to~', one or more portions may be arranged between two other portions unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

In describing elements of the present disclosure, the terms "first", "second", etc. may be used. These terms are intended to identify the corresponding elements from the other elements, and basis, order, or number of the corresponding elements are not limited by these terms. The expression that an element is "connected" or "coupled" to another element should be understood that the element may directly be connected or coupled to another element but may directly be connected or coupled to another element unless specially mentioned, or a third element may be interposed between the corresponding elements.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in co-dependent relationship.

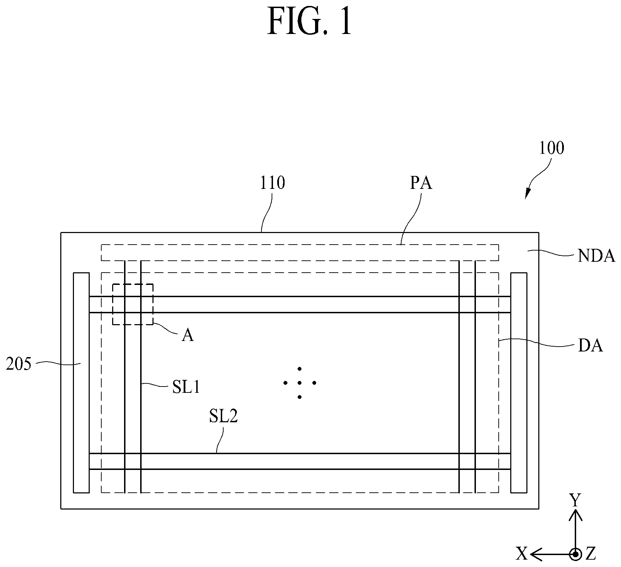

FIG. 1 is a schematic plane view illustrating a transparent display panel.

Hereinafter, X axis indicates a line parallel with a scan line, Y axis indicates a line parallel with a data line, and Z axis indicates a height direction of a transparent display device 100.

Although a description has been described based on that the transparent display device 100 according to one embodiment of the present disclosure is embodied as an organic light emitting display device, the transparent display device 100 may be embodied as a liquid crystal display device, a plasma display panel (PDP), a Quantum dot Light Emitting Display (QLED) or an Electrophoresis display device.

Referring to FIG. 1, a transparent display device 100 according to one embodiment of the present disclosure includes a transparent display panel 110, a source drive integrated circuit (hereinafter, referred to as "IC"), a flexible film, a circuit board, and a timing controller.

The transparent display panel 110 may include a display area DA provided with pixels P to display an image, and a non-display area NDA for not displaying an image.

The display area DA may be provided with a first signal lines SL1, a second signal lines SL2 and the pixels. The non-display area NDA may be provided with a pad area PA in which pads are disposed, and at least one scan driver 205.

The first signal lines SL1 may be extended in a first direction (e.g., Y-axis direction). The first signal lines SL1 may cross the second signal lines SL2 in the display area DA. The pixel may be provided in an area where the first signal line SL1 and the second signal line SL2 cross each other, and emits predetermined light to display an image.

The scan driver 205 are connected to the scan lines and supplies scan signals to the scan lines. The scan driver 205 may be disposed in the non-display area NDA on one side or both sides of the display area DA of the transparent display panel 110by a gate driver in panel (GIP) method or a tape automated bonding (TAB) method.

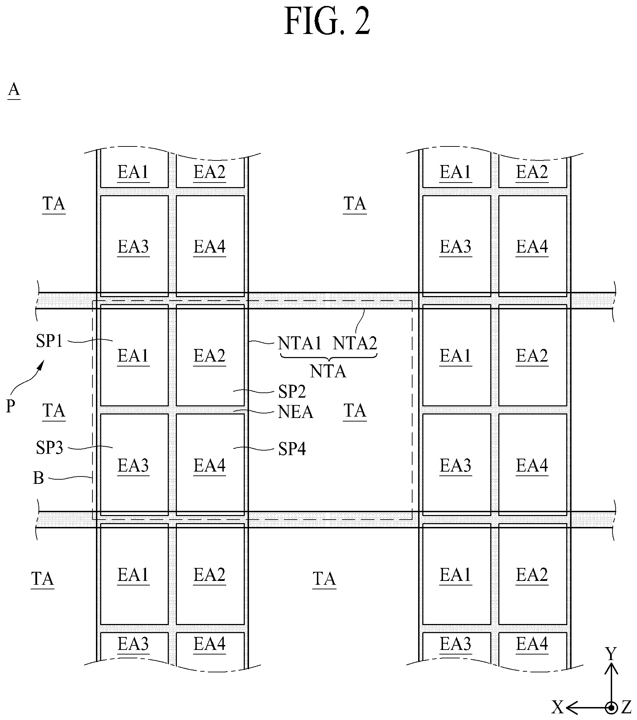

The transparent display panel 110 may further include a touch line and a touch sensor in addition to the first signal line SL1, the second signal line SL2 and the pixel in order to implement a touch function. A detailed description of the touch line and the touch sensor will be described later with reference to FIGS. 2 to 13.

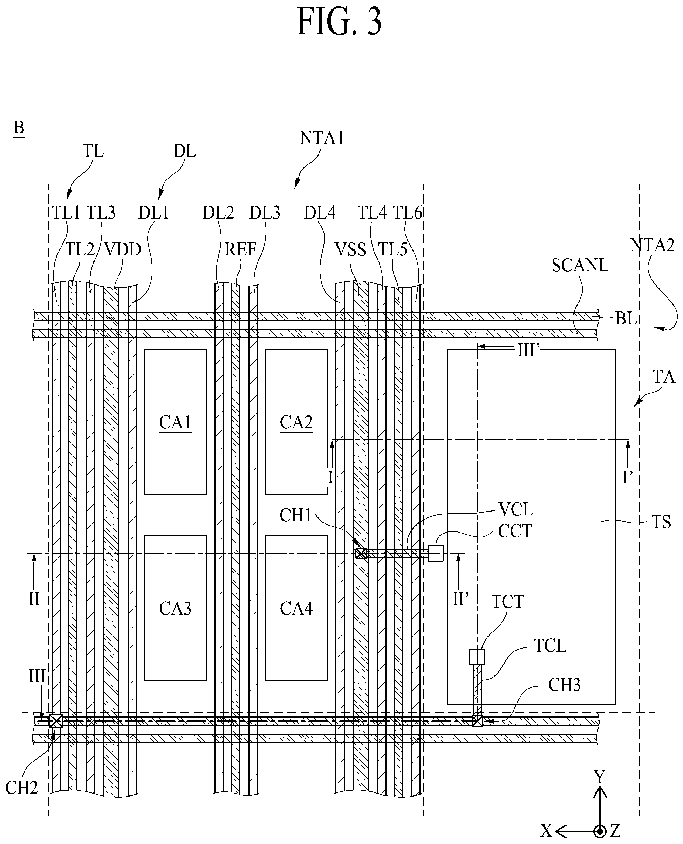

FIG. 2 is a schematic view illustrating an example of a pixel provided in an area A of FIG. 1, and FIG. 3 is a view illustrating an example of signal lines, touch lines and a touch sensor, which are provided in an area B of FIG. 2.

The display area DA, as shown in FIG. 2, includes a transmissive area TA and a non-transmissive area NTA. The transmissive area TA is an area through which most of externally incident light passes, and the non-transmissive area NTA is an area through which most of externally incident light fails to transmit. For example, the transmissive area TA may be an area where light transmittance is greater than α%, for example, about 90%, and the non-transmissive area NTA may be an area where light transmittance is smaller than β%, for example, about 50%. At this time, α is greater than β. A user may view an object or background arranged over a rear surface of the transparent display panel 110 due to the transmissive area TA.

The non-transmissive area NTA may include a first non-transmissive area NTA1, a second non-transmissive area NTA2 and a plurality of pixels P.

Pixels P may be provided to overlap at least one of the first signal line SL1 and the second signal line SL2, thereby emitting predetermined light to display an image. A light emission area EA may correspond to an area, from which light is emitted, in the pixel P.

Each of the pixels P, as shown in FIG. 2, may include at least one of a first subpixel SP1, a second subpixel SP2, a third subpixel SP3 and a fourth subpixel SP4. The first subpixel SP1 may include a first light emission area EA1 emitting light of a first color. The second subpixel SP2 may include a second light emission area EA2 emitting light of a second color. The third subpixel SP3 may include a third light emission area EA3 emitting light of a third color. The fourth subpixel SP4 may include a fourth light emission area EA4 emitting light of a fourth color.

The first to fourth light emission area EA1, EA2, EA3 and EA4 may emit light of different colors. For example, the first light emission area EA1 may emit light of a green color. The second light emission area EA2 may emit light of a red color. The third light emission area EA3 may emit light of a blue color. The fourth light emission area EA4 may emit light of a white color. However, the emission areas are not limited to this example. Each of the pixels P may further include a subpixel emitting light of a color other than red, green, blue and white. Also, the arrangement order of the subpixels SP1, SP2, SP3 and SP4 may be changed in various ways.

The first non-transmissive area NTA1 may be extended in a first direction (Y-axis direction) in a display area DA, and may be disposed to at least partially overlap light emission areas EA1, EA2, EA3 and EA4. A plurality of first non-transmissive areas NTA1 may be provided in the transparent display panel 110, and a transmissive area TA may be provided between two adjacent first non-transmissive areas NTA1. In the first non-transmissive area NTA1, first signals lines extended in the first direction (Y-axis direction) and touch lines TL extended in the first direction (Y-axis direction) may be disposed to be spaced apart from each other.

For example, the first signal lines may include at least one of a pixel power line VDD, a common power line VSS, a reference line REF or data lines DL1, DL2, DL3 and DL4.

The pixel power line VDD may supply a first power source to a driving transistor TFT of each of subpixels SP1, SP2, SP3 and SP4 provided in the display area DA.

The common power line VSS may supply a second power source to a cathode electrode CE of the subpixels SP1, SP2, SP3 and SP4 provided in the display area DA. At this time, the second power source may be a common power source commonly supplied to the subpixels SP1, SP2, SP3 and SP4.

The common power line VSS may supply the second power source to the cathode electrode CE through a cathode contact portion CCT provided between the transmissive area TA and the common power line VSS. A power connection line VCL may be disposed between the common power line VSS and the cathode contact portion CCT. One end of the power connection line VCL may be connected to the common power line VSS and the other end thereof may be connected to the cathode contact portion CCT. The cathode electrode CE may be connected to the cathode contact portion CCT. As a result, the cathode electrode CE may be electrically connected to the common power line VSS through the power connection line VCL and the cathode contact portion CCT.

The reference line REF may supply an initialization voltage (or sensing voltage) to the driving transistor TFT of each of the subpixels SP1, SP2, SP3 and SP4 provided in the display area DA.

The reference line REF may be disposed between the plurality of data lines DL1, DL2, DL3 and DL4. For example, the reference line REF may be disposed at the center of the plurality of data lines DL1, DL2, DL3 and DL4, that is, between the second data line DL2 and the third data line DL3.

The reference line REF may be diverged and connected to the plurality of subpixels SP1, SP2, SP3 and SP4. In detail, the reference line REF may be connected to circuit elements of the plurality of subpixels SP1, SP2, SP3 and SP4 to supply a reference signal to each of the subpixels SP1, SP2, SP3 and SP4.

When the reference line REF is disposed to be close to an edge of the first non-transmissive area NTA1, a deviation between connection lengths from the diverged point to the circuit element of each of the plurality of subpixels SP1, SP2, SP3 and SP4 is increased. For example, when the reference line REF is disposed at the leftmost side of the area where the first non-transmissive area NTA1 is provided, the connection length from the diverged point to the circuit element disposed over a right side of the first non-transmissive area NTA1 may be greater than the connection length from the diverged point to the circuit element disposed over a left side of the first non-transmissive area NTA1. In this case, a difference between the signal supplied to the circuit area disposed over the right side of the first non-transmissive area NTA1 and the signal supplied to the circuit area disposed over the left side of the first non-transmissive area NTA1 may occur.

In the transparent display panel 110 according to one embodiment of the present disclosure, the reference line REF may be disposed in a middle area of the first non-transmissive area NTA1, whereby the deviation between the connection lengths to the circuit elements of the respective subpixels SP1, SP2, SP3 and SP4 may be reduced or minimized. Therefore, the reference line REF may uniformly supply signals to the circuit element of each of the plurality of subpixels SP1, SP2, SP3 and SP4.

Each of the data lines DL1, DL2, DL3 and DL4 may supply a data voltage to the subpixels SP1, SP2, SP3 and SP4. For example, the first data line DL1 may supply a first data voltage to the first driving transistor TFT of the first subpixel SP1, the second data line DL2 may supply a second data voltage to the second driving transistor TFT of the second subpixel SP2, the third data line DL3 may supply a third data voltage to the third driving transistor TFT of the third subpixel SP3, and the fourth data line DL4 may supply a fourth data voltage to the fourth driving transistor TFT of the fourth subpixel SP4.

In the transparent display panel 110 according to one embodiment of the present disclosure, the touch line TL may be further disposed in the first non-transmissive area NTA1.

At least two touch lines TL may be provided in the first non-transmissive area NTA1. When the plurality of touch lines TL are disposed in the transmissive area TA of the transparent display panel 110, light transmittance may be deteriorated due to the plurality of touch lines TL.

Also, a slit, specifically an elongated linear or rectangular shape, may be formed between the plurality of touch lines TL. When external light passes through the slit, a diffraction phenomenon may occur. According to the diffraction phenomenon, light corresponding to plane waves may be changed to spherical waves as the light passes through the slit, and an interference phenomenon may occur in the spherical waves. Therefore, constructive interference and destructive interference occur in the spherical waves, whereby the external light that has passed through the slit may have irregular light intensity. As a result, in the transparent display panel 110, definition of an object or image positioned at an opposite side may be reduced. For this reason, the plurality of touch lines TL are preferably disposed in the first non-transmissive area NTA1 rather than the transmissive area TA.

The plurality of touch lines TL may be disposed between the first signal lines and the transmissive area TA in the first non-transmissive area NTA1 as shown in FIG. 3. For example, six touch lines TL1, TL2, TL3, TL4, TL5 and TL6 may be disposed in one first non-transmissive area NTA1. The three touch lines TL1, TL2 and TL3 may be disposed between the pixel power line VDD and the transmissive area TA, and the other three touch lines TL4, TL5 and TL6 may be disposed between the common power line VSS and the transmissive area TA, but the touch lines are not limited to this arrangement.

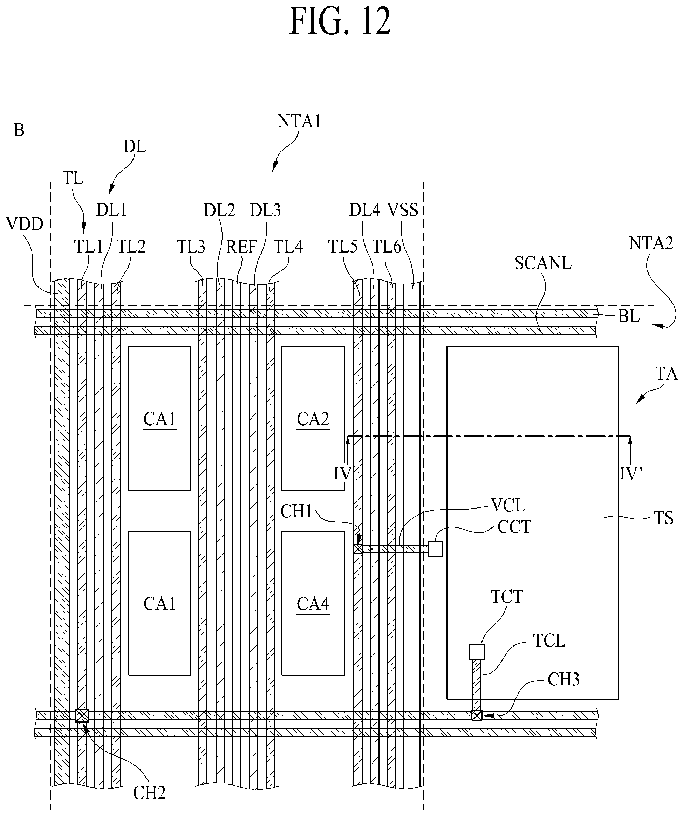

The plurality of touch lines TL may not overlap the circuit areas CA1, CA2, CA3 and CA4 in which the circuit elements are disposed, and various modifications may be made in the arrangement order of the plurality of touch lines TL and the first signal lines. In another embodiment, the plurality of touch lines TL may be disposed between the first signal lines as shown in FIG. 12. Each of the six touch lines TL1, TL2, TL3, TL4, TL5 and TL6 may be disposed between the first signal lines disposed in the order of the pixel power line VDD, the first data line DL1, the second data line DL2, the reference line REF, the third data line DL3, the fourth data line DL4 and the common power line VSS.

The transparent display panel 110 according to one embodiment of the present disclosure includes a pixel P between adjacent transmissive areas TA, and the pixel P may include light emission areas EA1, EA2, EA3 and EA4 in which a light emitting element is disposed to emit light. Since a size of the non-transmissive area NTA is small in the transparent display panel 110, the circuit element may be disposed to at least partially overlap the light emission areas EA1, EA2, EA3 and EA4. That is, the light emission areas EA1, EA2, EA3 and EA4 may include circuit areas CA1, CA2, CA3 and CA4 in which the circuit elements are disposed.

For example, the circuit areas may include a first circuit area CA1 in which a circuit element connected to the first subpixel SP1 is disposed, a second circuit area CA2 in which a circuit element connected to the second subpixel SP2 is disposed, a third circuit area CA3 in which a circuit element connected to the third subpixel SP3 is disposed, and a fourth circuit area CA4 in which a circuit element connected to the fourth subpixel SP4 is disposed.

In the transparent display panel 110 according to one embodiment of the present disclosure, the plurality of touch lines TL do not overlap the circuit areas CA1, CA2, CA3 and CA4, whereby parasitic capacitance of the touch lines TL due to the circuit elements may be reduced or minimized.

Furthermore, the transparent display panel 110 according to one embodiment of the present disclosure may reduce a horizontal distance difference between the touch lines TL. Since at least two transistors and a capacitor are disposed in the circuit areas CA1, CA2, CA3 and CA4, the touch lines TL may be difficult to be formed in a straight line in the circuit areas CA1, CA2, CA3, and CA4, and may be difficult to have a constant horizontal distance. Therefore, the horizontal distance difference between the touch lines TL is increased, whereby uniformity of the parasitic capacitance may be very low.

In the transparent display panel 110 according to one embodiment of the present disclosure, the touch lines TL may be disposed so as not to overlap the circuit areas CA1, CA2, CA3 and CA4, whereby an influence of the circuit element may be reduced and at the same time the horizontal distance difference between the touch lines TL may be reduced to improve uniformity of the parasitic capacitance.

The second non-transmissive area NTA2 may be extended in the display area DA in a second direction (X-axis direction), and may be disposed to at least partially overlap the light emission areas EA1, EA2, EA3 and EA4. A plurality of second non-transmissive areas NTA2 may be provided in the transparent display panel 110, and the transmissive area TA may be provided between two adjacent second non-transmissive areas NTA2. The second signal line and a bridge line BL may be disposed to be spaced apart from each other in the second non-transmissive area NTA2.

The second signal line may be extended in the second direction (X-axis direction), and may include, for example, a scan line SCANL. The scan line SCANL may supply a scan signal to the subpixels SP1, SP2, SP3 and SP4 of the pixel P.

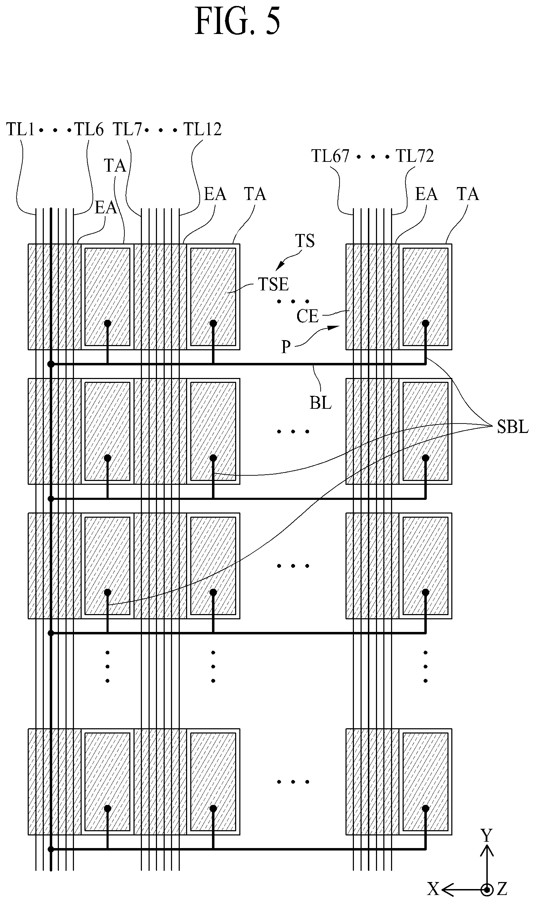

The bridge line BL may connect any one of the plurality of touch lines TL with the touch sensor TS. As shown in FIG. 5, the bridge line BL extending in the x-axis direction may include a sub bridge line SBL extending in the y-axis direction to connect with a touch sensor TS. The sub bridge line SBL of the bridge line BL may be connected to any one of the plurality of touch lines TL through a second contact hole CH2. Further, the sub bridge line SBL of the bridge line BL may be connected to at least two touch sensors TS arranged in the second direction (X-axis direction) through a third contact hole CH3 while being extended in the second direction (X-axis direction).

In the transparent display panel 110 according to one embodiment of the present disclosure, the plurality of touch lines TL may be disposed in the first non-transmissive area NTA1 not the second non-transmissive area NTA2, whereby light transmittance may be prevented from being deteriorated due to the plurality of touch lines TL. The second non-transmissive area NTA2 extended in the second direction (X-axis direction) crosses between the transmissive areas TA adjacent to each other as shown in FIG. 3. When a width of the second non-transmissive area NTA2 crossing the transmissive areas TA is increased, the size of the transmissive area TA may be reduced.

When the plurality of touch lines TL are disposed in the second non-transmissive area NTA2, the width of the second non-transmissive area NTA2 is increased to dispose a large number of lines, and the size of the transmissive area TA is reduced. That is, a problem may occur in that light transmittance of the transparent display panel 110 is reduced due to the plurality of touch lines TL.

In the transparent display panel 110 according to one embodiment of the present disclosure, the plurality of touch lines TL are disposed in the first non-transmissive area NTA1, and only one bridge line BL for connecting the plurality of touch sensors TS is provided in the second non-transmissive area NTA2. Therefore, the transparent display panel 110 according to one embodiment of the present disclosure may reduce or minimize decrease in the size of the transmissive area TA or decrease of light transmittance due to the plurality of touch lines TL and the bridge line BL.

The touch sensor TS may be provided in the transmissive area TA. The touch sensor TS may be disposed in each of the plurality of transmissive areas TA, and may be changed in capacitance during user contact. A touch driver (not shown) may be connected to the plurality of touch sensors TS through the plurality of touch lines TL to detect a change in capacitance of the plurality of touch sensors TS.

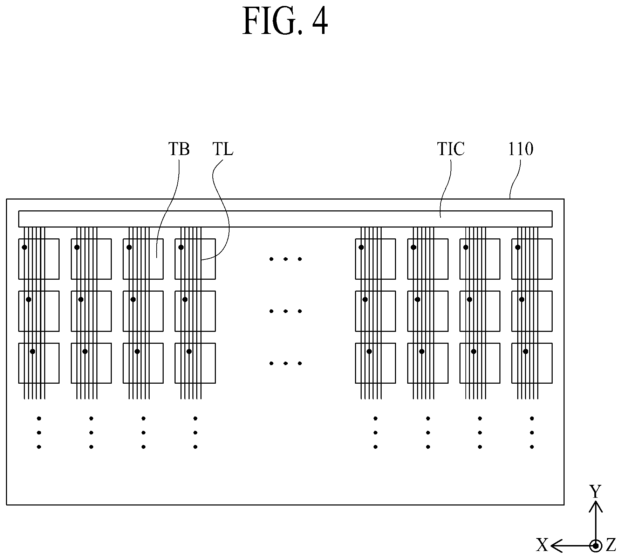

Hereinafter, a connection relation between the plurality of touch sensors and the plurality of touch lines will be described in more detail with reference to FIGS. 4 and 5.

FIG. 4 is a view illustrating a connection relation between a plurality of touch blocks and a plurality of touch lines, and FIG. 5 is a view illustrating a connection relation between a plurality of touch lines and a plurality of touch sensors in one touch block.

Referring to FIGS. 4 to 5, the transparent display panel 110 according to one embodiment of the present disclosure may include a plurality of touch blocks TB. Each of the plurality of touch blocks TB may include a plurality of pixels P and a plurality of transmissive areas TA disposed to correspond to the plurality of pixels P one-to-one as a basic unit for determining a user touch position.

As shown in FIG. 5, the transparent display panel 110 according to one embodiment of the present disclosure may include a touch sensor TS in the transmissive area TA. For example, each of the plurality of touch blocks TB may include 12X15 pixels P and 12X15 touch sensors TS. In this case, when image resolution is 1920X1080, touch resolution may be 160X72.

At this time, the touch sensor TS may include a touch sensor electrode TSE. The touch sensor electrode TSE may be formed of the same material in the same layer as the cathode electrode CE of the pixel P. In this case, the touch sensor electrode TSE and the cathode electrode CE may be disposed to be spaced apart from each other.

In the transparent display panel 110 according to one embodiment of the present disclosure, as each of the plurality of touch lines TL is connected to one of the plurality of touch blocks TB, a change in capacitance of the touch sensors TS provided in the connected touch block TB may be sensed. That is, the plurality of touch lines TL provided in the transparent display panel 110 may correspond to the plurality of touch blocks TB one-to-one. Therefore, the number of touch lines TL may be the same as the number of touch blocks TB in the transparent display panel 110. For example, when the number of touch blocks TB is 160X72, the touch line TL may also be 160X72, and may be connected to the touch driver TIC.

As described above, in order to form the touch lines TL as much as the number of touch blocks TB, at least two touch lines TL should be provided in one first non-transmissive area NTA1. For example, when image resolution is 1920X1080 and touch resolution is 160X72, six touch lines TL1, TL2, TL3, TL4, TL5 and TL6 may be provided in one first non-transmissive area NTA1, as shown in FIGS. 3 and 5, in order to form 160X72 touch lines TL in the transparent display panel 110.

The plurality of touch sensors TS provided in one touch block TB may be connected to one of the plurality of touch lines TL provided in one touch block TB as shown in FIG. 5. For example, twelve first non-transmissive areas NTA1 may be provided in one touch block TB, and six touch lines TL1, TL2, TL3, TL4, TL5 and TL6 may be disposed in each of the twelve first non-transmissive areas NTA1. As a result, one touch block TB may be provided with 72 touch lines TL1, ..., TL72. In this case, the plurality of touch sensors TS provided in one touch block TB may be connected to one specific touch line TL of one of the 72 touch lines TL1, ..., TL72. At this time, the specific touch line TL may be connected to the plurality of touch sensors TS arranged in the second direction (X-axis direction) through the bridge lines BL extended in the second direction (X-axis direction).

As described in, each of the plurality of touch lines TL may correspond to the touch blocks TB one-to-one. Each touch line TL connects the plurality of touch sensors TS provided in a corresponding touch block TB to the touch driver TIC. In detail, each touch line TL may transfer the changed capacitance provided from the touch sensors TS provided in the touch block TB to the touch driver TIC. The touch driver TIC may sense the change in capacitance, and may determine a touch position of a user. Further, each touch line TL may provide a sensing voltage generated from the touch driver TIC to the touch sensors TS provided in the touch block TB.

Referring back to FIG. 3, the touch sensor TS may be connected to any one of the plurality of touch lines TL through a touch contact portion TCT (herein also referred to as touch sensor contact portion TCT), the touch connection line TCL and the bridge line BL, which are disposed in the transmissive area TA. In detail, the touch connection line TCL may be disposed between the bridge line BL and the touch contact portion TCT, such that one end thereof may be connected to the bridge line BL and the other end thereof may be connected to the touch contact portion TCT. The bridge line BL may be connected to any one of the plurality of touch lines TL through the second contact hole CH2. As a result, the touch sensor TS may be connected to the touch contact portion TCT and thus connected to any one of the plurality of touch lines TL through the touch contact portion TCT, the touch connection line TCL and the bridge line BL.

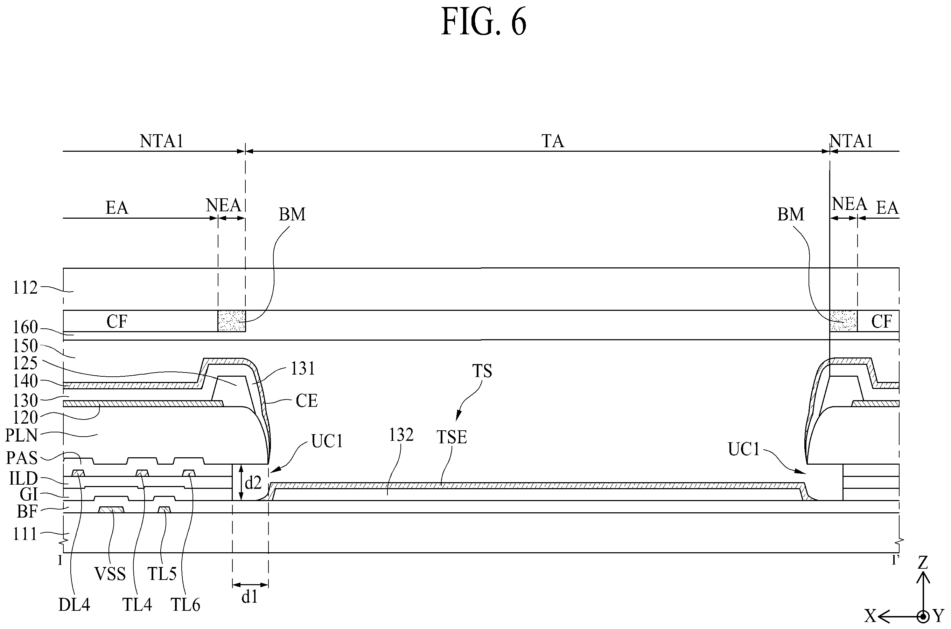

Hereinafter, a connection structure of the touch sensor TS and the cathode electrode of the pixel P, a connection structure of the touch sensor TS and the touch line TL and a connection structure of the cathode electrode CE of the pixel P and the common power line VSS will be described in more detail with reference to FIGS. 6 to 13.

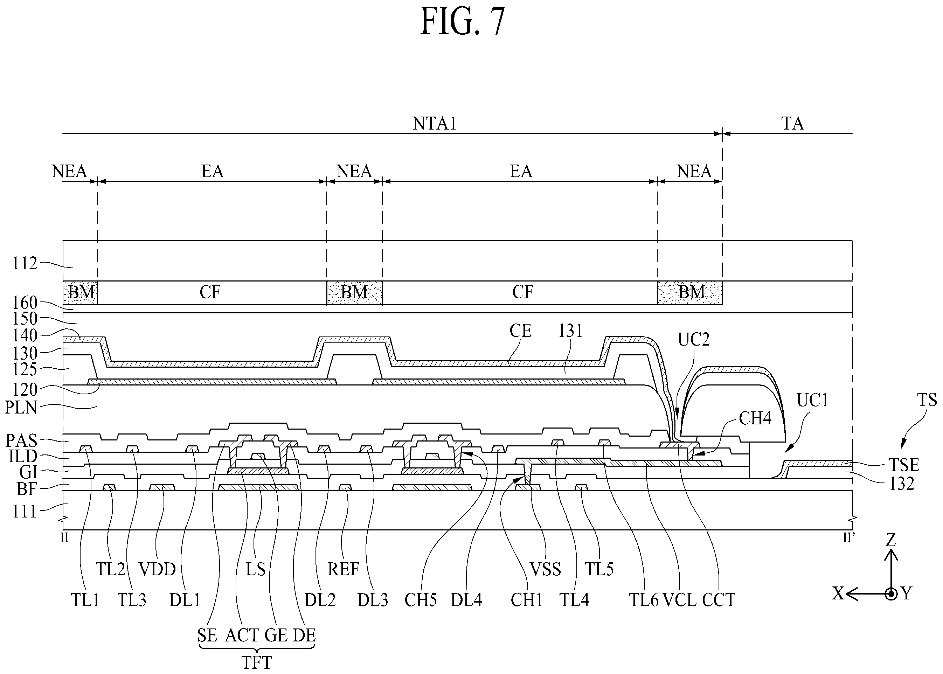

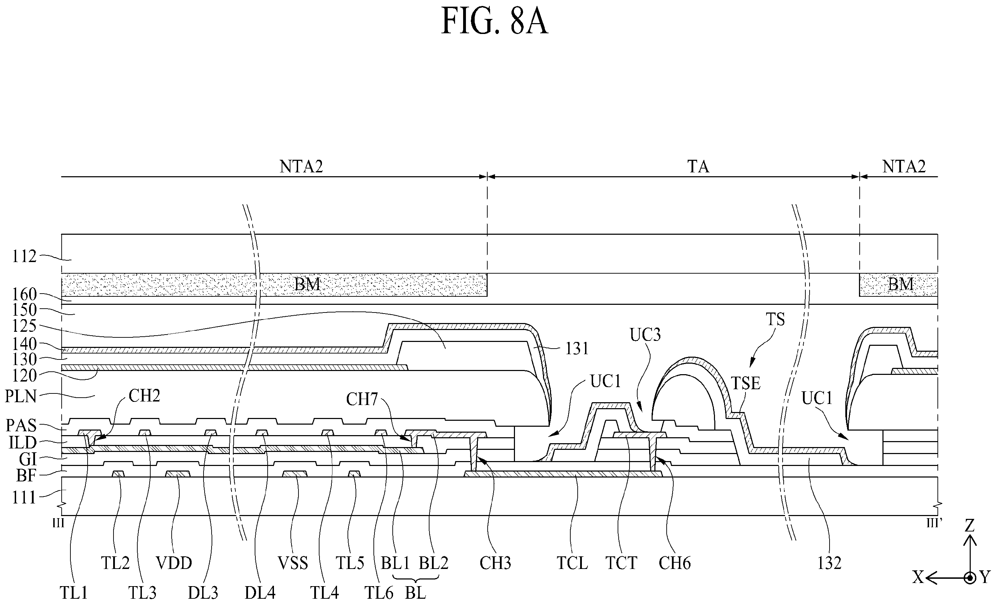

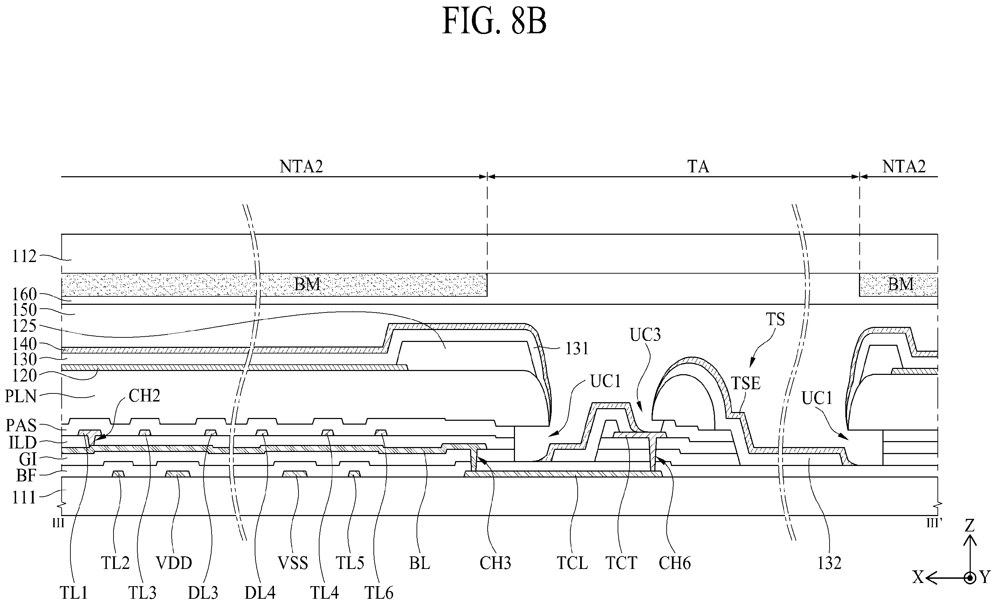

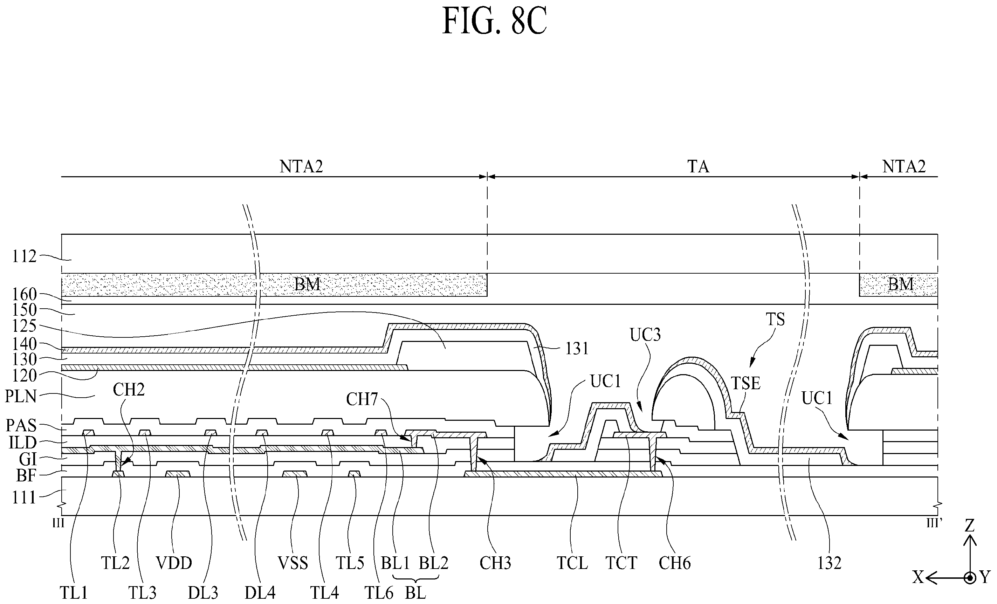

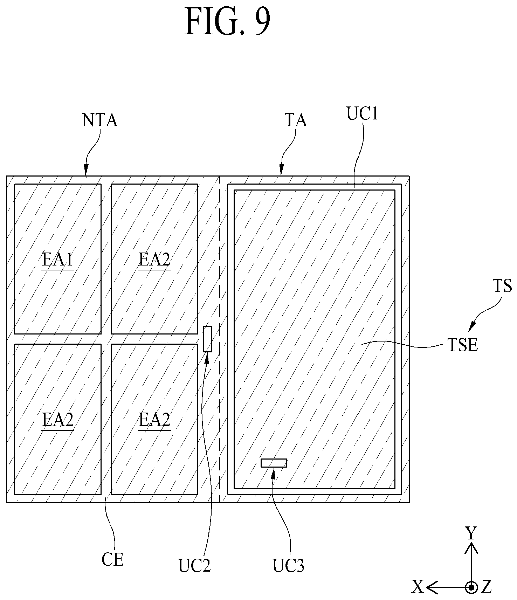

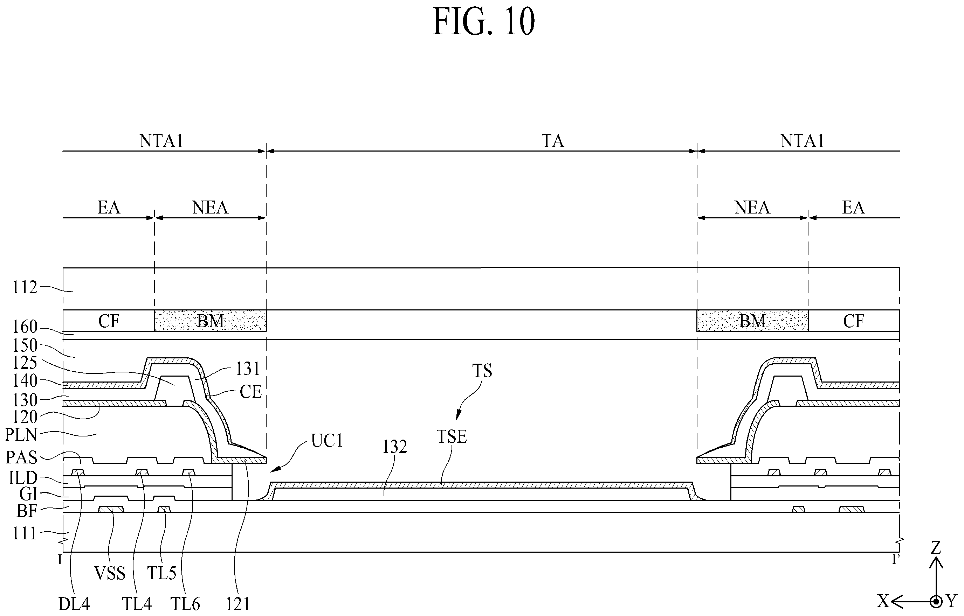

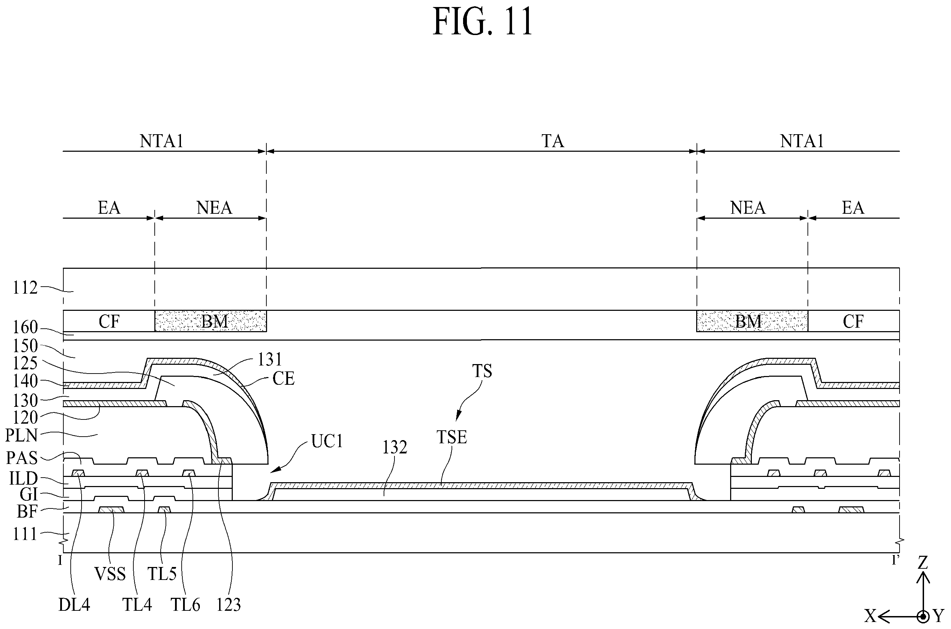

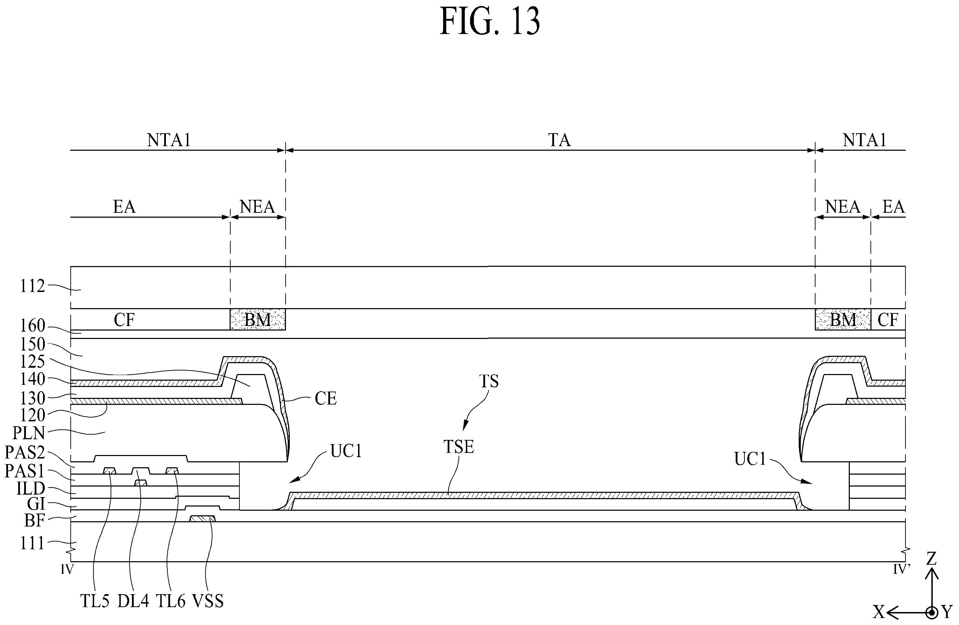

FIG. 6 is a cross-sectional view taken along line I-I' of FIG. 3, FIG. 7 is a cross-sectional view taken along line II-II' of FIG. 3, FIG. 8A is a cross-sectional view taken along line III-III' of FIG. 3, FIG. 8B is a cross-sectional view illustrating a modified example of FIG. 8A, FIG. 8C is a cross-sectional view illustrating another modified example of FIG. 8A, FIG. 9 is a view illustrating an example that a cathode electrode, a touch sensor electrode, a first undercut structure, a second undercut structure and a third undercut structure are disposed, FIG. 10 is a view illustrating another undercut structure for comparison with the first undercut structure shown in FIG. 6, FIG. 11 is a view illustrating other undercut structure for comparison with the first undercut structure shown in FIG. 6, FIG. 12 is a view illustrating a modified example of FIG. 3, and FIG. 13 is a cross-sectional view taken along line IV-IV' of FIG. 12.

Referring to FIGS. 3, 6 to 13, a first substrate 111 of the transparent display panel 110 according to one embodiment of the present disclosure may include a plurality of transmissive areas TA and a non-transmissive area NTA that includes a plurality of light emission areas EA disposed between the adjacent transmissive areas TA. The non-transmissive area NTA may include a first non-transmissive area NTA1 extended in the first direction (Y-axis direction) and a second non-transmissive area NTA2 extended in the second direction (X-axis direction).

The first non-transmissive area NTA1 includes circuit areas CA1, CA2, CA3 and CA4 in which at least one transistor and a capacitor are disposed, and may be provided with a pixel power line VDD, a common power line VSS, a reference line REF, data lines DL and touch lines TL, which are extend in the first direction (Y-axis direction) and disposed so as not to overlap the circuit areas CA1, CA2, CA3 and CA4. The second non-transmissive area NTA2 may be provided with a second signal line and a bridge line, which are extended in the second direction (X-axis direction).

The at least one transistor may include a driving transistor TFT, a switching transistor, and a sensing transistor.

The switching transistor is switched in accordance with the scan signal supplied to the scan line to charge the data voltage, which is supplied from the data line, in the capacitor. The sensing transistor serves to sense a threshold voltage deviation of the driving transistor TFT, which causes deterioration of image quality, in accordance with a sensing signal. The driving transistor TFT is switched in accordance with the data voltage charged in the capacitor to generate a data current from a power source supplied from the pixel power line VDD, thereby supplying the data current to the first electrode 120 of the subpixels SP1, SP2, SP3 and SP4. The driving transistor TFT may include an active layer ACT, a gate electrode GE, a source electrode SE and a drain electrode DE.

In detail, a light shielding layer LS may be provided over the first substrate 111. The light shielding layer LS serves to shield external light incident on the active layer ACT in the area where the driving transistor TFT is provided. The light shielding layer LS may be formed of a single layer or multiple layers made of any one of molybdenum (Mo), aluminum (Al), chromium (Cr), gold (Au), titanium (Ti), nickel (Ni), neodymium (Nd) and copper (Cu) or their alloy.

As shown in FIGS. 6 to 8C, in the transparent display panel 110 according to one embodiment of the present disclosure, at least a portion of the pixel power line VDD, the common power line VSS, the reference line REF, the data lines DL and the touch lines TL may be formed in the same layer as the light shielding layer LS. For example, some (TL2 and TL5) of the touch lines TL, the pixel power line VDD, the reference line REF and the common power line VSS may be formed of the same material in the same layer as the light shielding layer LS. In FIGS. 6 to 8C, the second touch line TL2, the pixel power line VDD, the reference line REF, the common power line VSS and the fifth touch line TL5 are shown as being formed in the same layer as the light shielding layer LS, but are not limited thereto.

In the transparent display panel 110 according to one embodiment of the present disclosure, the signal lines formed in the same layer as the light shielding layer LS may be varied depending on the arrangement order of the pixel power line VDD, the common power line VSS, the reference line REF, the data lines DL and the touch lines TL. However, in the transparent display panel 110 according to one embodiment of the present disclosure, two signal lines disposed to be adjacent to each other may not be disposed in the same layer as the light shielding layer LS. That is, one of the two adjacent signal lines may be disposed in the same layer as the light shielding layer LS, and the other of the two adjacent signal lines may be disposed in a layer different from that of the light shielding layer LS, for example, in the same layer as the gate electrode GE or the source electrode SE and the drain electrode DE. Therefore, the transparent display panel 110 according to one embodiment of the present disclosure may make sure of a spaced distance between the signal lines.

As shown in FIGS. 8A to 8C, in the transparent display panel 110 according to one embodiment of the present disclosure, the touch connection line TCL may be formed of the same material as that of the light shielding layer LS in the same layer as the light shielding layer LS. One end of the touch connection line TCL may be connected to the bridge line BL through the third contact hole CH3, and the other end thereof may be connected to the touch contact portion TCT through a sixth contact hole CH6. At this time, since the touch connection line TCL is extended from the bridge line BL disposed in the second non-transmissive area NTA2 to the touch contact portion TCT disposed in the transmissive area TA, the touch connection line TCL has no option but to cross a first undercut structure UC1. The first undercut structure UC1 may be formed through a wet etching process. The transparent display panel 110 according to one embodiment of the present disclosure may be formed in the same layer as the light shielding layer LS in order to prevent the touch connection line TCL from being lost during the wet etching process for forming the first undercut structure UC1.

A buffer layer BF may be provided over the touch lines TL2 and TL5, the pixel power line VDD, the reference line REF, the common power line VSS and the touch connection line TCL. The buffer layer BF is for protecting the transistors TFT from water permeated through the first substrate 111 vulnerable to moisture permeation, and may be formed of an inorganic layer, for example, a silicon oxide layer (SiOx), a silicon nitride layer (SiNx), or multiple layers of SiOx and SiNx.

The active layer ACT may be provided over the buffer layer BF. The active layer ACT may be formed of a silicon-based semiconductor material or an oxide-based semiconductor material.

A gate insulating layer GI may be provided over the active layer ACT. The gate insulating layer GI may be provided in the non-transmissive area NTA, and may not be provided in at least a portion of the transmissive area TA to improve light transmittance in the transmissive area TA and form the first undercut structure UC1. The gate insulating layer GI may be formed of an inorganic layer, for example, a silicon oxide layer (SiOx), a silicon nitride layer (SiNx), or multiple layers of SiOx and SiNx.

A gate electrode GE may be provided over the gate insulating layer GI. The gate electrode GE may be formed of a single layer or multiple layers made of one of molybdenum (Mo), aluminum (Al), chromium (Cr), gold (Au), titanium (Ti), nickel (Ni), neodymium (Nd) and copper (Cu), or their alloy.

As shown in FIG. 7, in the transparent display panel 110 according to one embodiment of the present disclosure, the power connection line VCL may be formed of the same material as that of the gate electrode GE in the same layer as the gate electrode. One end of the power connection line VCL may be connected to the common power line VSS through a first contact hole CH1, and the other end thereof may be connected to the cathode contact portion CCT through a fourth contact hole CH4.

In FIG. 7, that the power connection line VCL is shown as being directly connected to the common power line VSS through the first contact hole CH1, but is not limited thereto. In another embodiment, the power connection line VCL may be connected to the common power line VSS using a separate connection pattern (not shown) provided in a layer different from the power connection line VCL. For example, the connection pattern may be disposed in the same layer as the source electrode SE and the drain electrode DE, and may be directly connected to the common power line VSS. The power connection line VCL may be electrically connected to the common power line VSS by being connected to the connection pattern through a contact hole.

In addition, as shown in FIG. 8A, in the transparent display panel 110 according to one embodiment of the present disclosure, the first bridge line BL1 may be formed of the same material as that of the gate electrode GE in the same layer as the gate electrode GE. In detail, the bridge line BL may include a first bridge line BL1 formed of the same material as that of the gate electrode GE in the same layer as the gate electrode GE, and a second bridge line BL2 formed of the same material as that of the source electrode SE and the drain electrode DE in the same layer as the source electrode SE and the drain electrode DE. The first bridge line BL1 may be disposed in an area of the second non-transmissive area NTA1, which is overlapped with the first non-transmissive area NTA1, and thus may be connected to one of the touch lines TL1 through the second contact hole CH2. The second bridge line BL2 may be disposed in an area of the second non-transmissive area NTA2, which is not overlapped with the first non-transmissive area NTA1, and thus may be connected to the first bridge line BL1 through a seventh contact hole CH7.

In FIG. 8A, the bridge line BL is shown as being formed of two layers, but is not limited thereto. In another embodiment, the bridge line BL may be formed of only the first bridge line BL1 formed of the same material as that of the gate electrode GE in the same layer as the gate electrode GE. The first bridge line BL1 may be connected to one of the plurality of touch lines TL through the second contact hole CH2 in the area of the second non-transmissive area NTA2, which is not overlapped with the first non-transmissive area NTA1. Further, the first bridge line BL1 may be extended in the second direction (X-axis direction), and thus may be connected to the touch connection line TCL through the third contact hole CH3. In one embodiment, the touch connection line TCL includes a sub bridge line SBL as shown in FIG. 5.

In FIGS. 8A and 8B, the bridge line BL is shown as being connected to the touch line TL1 provided in the same layer as the source electrode SE and the drain electrode DE, but is not limited thereto. In another embodiment, as shown in FIG. 8C, the bridge line BL may be connected to the touch line TL2 provided in the same layer as the light shielding layer LS.

An interlayer dielectric layer ILD may be provided over the gate electrode GE, the power connection line VCL and the first bridge line BL1. The interlayer dielectric layer ILD may be provided in the non-transmissive area NTA, and may not be provided in at least a portion of the transmissive area TA to improve light transmittance in the transmissive area TA and form the first undercut structure UC1. The interlayer dielectric layer ILD may be formed of an inorganic layer, for example, a silicon oxide layer (SiOx), a silicon nitride layer (SiNx), or multiple layers of SiOx and SiNx.

The source electrode SE and the drain electrode DE may be provided over the interlayer dielectric layer ILD. The source electrode SE and the drain electrode DE may be connected to the active layer ACT through a fifth contact hole CH5 that passes through the gate insulating layer GI and the interlayer dielectric layer ILD. The source electrode SE and the drain electrode DE may be formed of a single layer or multiple layers made of one of molybdenum (Mo), aluminum (Al), chromium (Cr), gold (Au), titanium (Ti), nickel (Ni), neodymium (Nd) and copper (Cu), or their alloy.

In the transparent display panel 110 according to one embodiment of the present disclosure, as shown in FIGS. 6 to 8C, at least a portion of the pixel power line VDD, the common power line VSS, the reference line REF, the data lines DL and the touch lines TL may be formed in the same layer as the source electrode SE and the drain electrode DE. For example, some TL1, TL3, TL4 and TL6 of the plurality of touch lines TL may be formed of the same material as that of the source electrode and the drain electrode DE in the same layer as the source electrode SE and the drain electrode DE, but are not limited thereto.

Also, in the transparent display panel 110 according to one embodiment of the present disclosure, as shown in FIG. 7, the cathode contact portion CCT may be formed of the same material as that of the source electrode SE and the drain electrode DE in the same layer as the source electrode SE and the drain electrode DE. At least a portion of an upper surface of the cathode contact portion CCT may be exposed by a second undercut structure UC2, and the cathode electrode CE may be connected to the exposed upper surface of the cathode contact portion CCT. The cathode contact portion CCT may be connected to the power connection line VCL through the fourth contact hole CH4, and may transfer the power source supplied from the common power line VSS to the cathode electrode CE through the power connection line VCL.

In addition, as shown in FIGS. 8A to 8C, in the transparent display panel 110 according to one embodiment of the present disclosure, the touch contact portion TCT may be formed of the same material as that of the source electrode SE and the drain electrode DE in the same layer as the source electrode SE and the drain electrode DE. At least a portion of an upper surface of the touch contact portion TCT may be exposed by a third undercut structure UC3, and the touch sensor electrode TSE may be connected to the exposed upper surface. The touch contact portion TCT may be connected to the touch connection line TCL through the sixth contact hole CH6, and may transfer the change in capacitance of the touch sensor electrode TSE to the touch line TL through the touch connection line TCL and the bridge line BL.

When the bridge line BL is formed of two layers, in the transparent display panel 110 according to one embodiment of the present disclosure, as shown in FIGS. 8A to 8C, the second bridge line BL2 may be formed of the same material as that of the source electrode SE and the drain electrode DE in the same layer as the source electrode SE and the drain electrode DE. The second bridge line BL2 may be disposed in the area of the second non-transmissive area NTA2, which is not overlapped with the first non-transmissive area NTA1, and may be connected to the first bridge line BL1 at one end through the seventh contact hole CH7. The second bridge line BL2 may be connected to the touch connection line TCL through the third contact hole CH3.

A passivation layer PAS for insulating the driving transistor TFT may be provided over the source electrode SE, the drain electrode DE, the cathode contact portion CCT and the touch contact portion TCT. The passivation layer PAS may be provided in the non-transmissive area NTA, and may not be provided in at least a portion of the transmissive area TA to improve light transmittance in the transmissive area TA and form the first undercut structure UC1.

In addition, the passivation layer PAS may be provided such that at least a portion of the cathode contact portion CCT is exposed, for the formation of the second undercut structure UC2. The passivation layer PAS may be provided such that at least a portion of the touch contact portion TCT is exposed, for the formation of the third undercut structure UC3.

The passivation layer PAS may be formed of an inorganic layer, for example, a silicon oxide layer (SiOx), a silicon nitride layer (SiNx), or multiple layers of SiOx and SiNx.

A planarization layer PLN for planarizing a step difference due to the driving transistor TFT and the plurality of signal lines may be provided over the passivation layer PAS. The planarization layer PLN may be provided in the non-transmissive area NTA, and may not be provided in at least a portion of the transmissive area TA to improve light transmittance in the transmissive area TA and form the first undercut structure UC1.

The planarization layer PLN may be formed of an organic layer such as an acrylic resin, an epoxy resin, a phenolic resin, a polyamide resin and a polyimide resin.

In the transparent display panel 110 according to one embodiment of the present disclosure, the first undercut structure UC1 may be formed using the planarization layer PLN and the plurality of inorganic insulating layers, for example, the passivation layer PAS, the interlayer dielectric layer ILD and the gate insulating layer GI. In detail, in the first undercut structure UC1, the planarization layer PLN may be formed to be more protruded toward the transmissive area TA than the plurality of inorganic insulating layers, for example, the passivation layer PAS, the interlayer dielectric layer ILD and the gate insulating layer GI. Therefore, the first undercut structure UC1 may expose at least a portion of a lower surface of the planarization layer PLN, and may form a gap space with the buffer layer BF without providing the plurality of inorganic insulating layers below the exposed lower surface.

The first undercut structure DC1 may be formed through a wet etching process. The wet etching process for forming the first undercut structure UC1 may be isotropic etching. Therefore, in the first undercut structure UC1, a first spaced distance d1 from an end of the planarization layer PLN to an end of the plurality of inorganic insulating layers may be the same as a second spaced distance d2 from a lower surface of the planarization layer PLN to an upper surface of the buffer layer BF. At this time, the first spaced distance d1 of the first undercut structure UC1 should have a minimum distance value, for example, 2um or more in order to ensure separation of the cathode electrode CE and the touch sensor electrode TSE. Therefore, since the second spaced distance d2 of the first undercut structure UC1 should be greater than or equal to 2um, a sum of thicknesses of the passivation layer PAS, the interlayer dielectric layer ILD and the gate insulating layer GI may be greater than or equal to 2um.

The first undercut structure UC1 may be provided in the transmissive area TA, and may have a planar closed shape. For example, the first undercut structure UC1 may be provided to surround the touch sensor TS along the edge of the transmissive area TA, as shown in FIG. 9.

In the transparent display panel 110 according to one embodiment of the present disclosure, an organic light emitting layer 130 and a second electrode 140 may be separated without being continuous between the non-transmissive area NTA and the transmissive area TA by the first undercut structure UC1. In detail, an organic light emitting layer 131 provided in the non-transmissive area NTA and an organic light emitting layer 132 provided in the transmissive area TA may be separated from each other by the first undercut structure UC1. In addition, a second electrode CE provided in the non-transmissive area NTA and a second electrode TSE provided in the transmissive area TA may be also separated from each other by the first undercut structure UC1. In this case, the second electrode CE provided in the non-transmissive area NTA may be the cathode electrode CE constituting the light emitting element, and the second electrode TSE provided in the transmissive area TA may be the touch sensor electrode TSE constituting the touch sensor TS.

In the transparent display panel 110 according to one embodiment of the present disclosure, the first undercut structure UC1 may be formed using the planarization layer PLN and the plurality of inorganic insulating layers, whereby light transmittance may be prevented from being reduced due to the first undercut structure UC1.

As shown in FIG. 10, the first undercut structure UC1 may be formed using a separate metal pattern 121 more protruded toward the transmissive area TA than the plurality of inorganic insulating layers. The metal pattern 121 may be formed of the same material as that of first electrode 120 in the same layer as the first electrode 120, and may be disposed to be spaced apart from the first electrode 120. In this case, since the metal pattern 121 is made of an opaque metal material, an area, in which the metal pattern 121 is provided, cannot be the transmissive area TA, and may be the non-transmissive area NTA. That is, since the first undercut structure DC1 shown in FIG. 10 reduces light transmittance, it is not preferable.

As shown in FIG. 11, the first undercut structure UC1 may be formed using a bank 125 more protruded toward the transmissive area TA than the plurality of inorganic insulating layers. Since the bank 125 is directly in contact with the organic light emitting layer 130, the bank 125 should be made of a material having good out-gassing. For example, the bank 125 may be made of polyimide. Since the polyimide does not have good adhesion with an inorganic layer, a metal pattern 123 may be provided between the bank 125 and the passivation layer PAS so that the bank 125 is not separated from the passivation layer PAS. The metal pattern 123 may be formed of the same material as that of the first electrode 120 in the same layer as the first electrode 120, and may be disposed to be spaced apart from the first electrode 120. In this case, since the metal pattern 123 is made of an opaque metal material, an area, in which the metal pattern 123 is provided, cannot be the transmissive area TA, and may be the non-transmissive area NTA. That is, since the first undercut structure UC1 shown in FIG. 11 reduces light transmittance, it is not preferable.

As a result, the first undercut structure UC1 shown in FIGS. 6 to 8C may prevent loss of light transmittance as compared with the first undercut structure UC1 shown in FIGS. 10 and 11.

Meanwhile, in the transparent display panel 110 according to one embodiment of the present disclosure, the second undercut structure UC2 may be formed using the planarization layer PLN and the passivation layer PAS. In detail, the second undercut structure UC2 may be formed in such a manner that the planarization layer PLN is more protruded than the passivation layer PAS in the direction in which the common power line VSS is disposed. Therefore, the second undercut structure UC2 may expose at least a portion of the lower surface of the planarization layer PLN, and may expose at least a portion of the upper surface of the cathode contact portion CCT without providing the passivation layer PAS below the exposed lower surface.

The second undercut structure UC2 may be disposed outside the area where the first undercut structure UC1 is provided. In detail, the second undercut structure UC2 may be disposed between the first undercut structure UC1 and the light emission area EA, as shown in FIG. 9.

In the transparent display panel 110 according to one embodiment of the present disclosure, the cathode electrode CE may be connected to the cathode contact portion CCT by the second undercut structure UC2. In detail, at least a portion of the upper surface of the cathode contact portion CCT may be exposed by the second undercut structure UC2. The cathode electrode CE may be deposited over the exposed upper surface of the cathode contact portion CCT, and thus may be connected to a cathode contact portion CCT.

Also, in the transparent display panel 110 according to one embodiment of the present disclosure, the third undercut structure UC3 may be formed using the planarization layer PLN and the passivation layer PAS. In detail, the third undercut structure UC3 may be formed in such a manner that the planarization layer PLN is more protruded than the passivation layer PAS in the direction in which the bridge line BL is disposed. Therefore, the third undercut structure UC3 may expose at least a portion of the lower surface of the planarization layer PLN, and may expose at least a portion of the upper surface of the touch contact portion TCT without providing the passivation layer PAS below the exposed lower surface.

The third undercut structure UC3 may be provided inside the area where the first undercut structure UC1 is provided. In detail, the third undercut structure UC3 may be disposed in the touch sensor TS as shown in FIG. 9.

In the transparent display panel 110 according to one embodiment of the present disclosure, the touch sensor electrode TSE may be connected to the touch contact portion TCT by the third undercut structure UC3. In detail, at least a portion of the upper surface of the touch contact portion TCT may be exposed by the third undercut structure UC3. The touch sensor electrode TSE may be deposited over the exposed upper surface of the touch contact portion TCT, and thus may be connected to the touch contact portion TCT.

A light emitting element, which includes a first electrode 120, an organic light emitting layer 130 and a cathode electrode CE, and a bank 125 may be provided over the planarization layer PLN.

The first electrode 120 may be provided over the planarization layer PLN for each of the subpixels SP1, SP2, SP3 and SP4. The first electrode 120 is not provided in the transmissive area TA.

The first electrode 120 may be connected to the driving transistor TFT. In detail, the first electrode 120 may be connected to one of the source electrode SE and the drain electrode DE of the driving transistor TFT through a contact hole (not shown) that passes through the planarization layer PLN and the passivation layer PAS.

The first electrode 120 may be formed of a metal material having high reflectance, such as a stacked structure (Ti/Al/Ti) of aluminum and titanium, a stacked structure (ITO/Al/ITO) of aluminum and ITO, an Ag alloy, a stacked structure (ITO/Ag alloy/ITO) of Ag alloy and ITO, a MoTi alloy, and a stacked structure (ITO/MoTi alloy/ITO) of MoTi alloy and ITO. The Ag alloy may be an alloy of silver (Ag), palladium (Pd), copper (Cu), etc. The MoTi alloy may be an alloy of molybdenum (Mo) and titanium (Ti). The first electrode 120 may be an anode electrode.

The bank 125 may be provided over the planarization layer PLN. The bank 125 may be provided to at least partially cover an edge of the first electrode 120 and expose a portion of the first electrode 120. Therefore, the bank 125 may prevent a problem in which light emitting efficiency is deteriorated due to concentration of a current on an end of the first electrode 120.

The bank 125 may define light emission areas EA1, EA2, EA3 and EA4 of the subpixels SP1, SP2, SP3 and SP4. The light emission areas EA1, EA2, EA3 and EA4 of each of the subpixels SP1, SP2, SP3 and SP4 represent an area in which the first electrode 120, the organic light emitting layer 130 and the cathode electrode CE are sequentially stacked and holes from the first electrode 120 and electrons from the cathode electrode CE are combined with each other in the organic light emitting layer 130 to emit light. In this case, the area in which the bank 125 is provided may become the non-light emission area NEA because light is not emitted therefrom, and the area in which the bank 125 is not provided and the first electrode is exposed may become the light emission area EA.

The bank 125 may be formed of an organic layer such as an acrylic resin, an epoxy resin, a phenolic resin, a polyamide resin, and a polyimide resin.

The organic light emitting layer 130 may be disposed over the first electrode 120. The organic light emitting layer 130 may include a hole transporting layer, a light emitting layer and an electron transporting layer. In this case, when a voltage is applied to the first electrode 120 and the cathode electrode CE, holes and electrons move to the light emitting layer through the hole transporting layer and the electron transporting layer, respectively and are combined with each other in the light emitting layer to emit light.

In one embodiment, the organic light emitting layer 130 may be a common layer commonly provided in the subpixels SP1, SP2, SP3 and SP4. In this case, the light emitting layer may be a white light emitting layer for emitting white light.

In another embodiment, the light emitting layer of the organic light emitting layer 130 may be formed for each of the subpixels SP1, SP2, SP3 and SP4. For example, a green light emitting layer for emitting green light may be provided in the first subpixel SP1, a red light emitting layer for emitting red light may be provided in the second subpixel SP2, a blue light emitting layer for emitting blue light may be provided in the third subpixel SP3, and a white light emitting layer for emitting white light may be provided in the fourth subpixel SP4. In this case, the light emitting layer of the organic light emitting layer 130 is not provided in the transmissive area TA.

The organic light emitting layer 130 may be separated without being continuous between the non-transmissive area NTA and the transmissive area TA by the first undercut structure UC1. In detail, an organic light emitting layer 131 of the organic light emitting layer 130, which is provided in the non-transmissive area NTA, and an organic light emitting layer 132 of the organic light emitting layer 130, which is provided in the transmissive area TA, may be separated from each other by the first undercut structure UC1. That is, the organic light emitting layer 131 of the organic light emitting layer 130, which is provided in the non-transmissive area NTA, and the organic light emitting layer 132 of the organic light emitting layer 130, which is provided in the transmissive area TA, may be spaced apart from each other by the first undercut structure UC1.

The second electrode 140 may be disposed over the organic light emitting layer 130 and the bank 125. When the second electrode 140 is deposited over the entire surface, the second electrode 140 may be separated without being continuous between the non-transmissive area NTA and the transmissive area TA by the first undercut structure UC1. In detail, the second electrode 140 may be divided into the second electrode CE provided in the non-transmissive area NTA and the second electrode TSE provided in the transmissive area TA by the first undercut structure UC1.

The second electrode CE provided in the non-transmissive area NTA may be the cathode electrode CE, and may be an element constituting the light emitting element. The cathode electrode CE may be connected to the cathode contact portion CCT exposed by the second undercut structure UC2 to receive the power source from the common power line VSS. The cathode electrode CE may be a common layer that is commonly provided in the subpixels SP1, SP2, SP3 and SP4 to apply the same voltage to the subpixels.

The second electrode TSE provided in the transmissive area TA may be the touch sensor electrode TSE, and may be an element constituting the touch sensor TS. The touch sensor electrode TSE may be connected to the touch contact portion TCT exposed by the third undercut structure UC3 to provide a change in capacitance to the touch line TL.

The second electrode 140, which includes the cathode electrode CE and the touch sensor electrode TSE, may be formed of a transparent conductive material (TCO) such as ITO and IZO, which may transmit light, or a semi-transmissive conductive material such as magnesium (Mg), silver (Ag) or an alloy of magnesium (Mg) and silver (Ag). When the second electrode 140 is formed of a semi-transmissive conductive material, light emitting efficiency may be increased by a micro cavity.

An encapsulation layer 150 may be provided over the light emitting elements and the touch sensors TS. The encapsulation layer 150 may be provided over the cathode electrode CE and the touch sensor electrode TSE to at least partially cover the cathode electrode CE and the touch sensor electrode TSE.

The encapsulation layer 150 serves to prevent oxygen or water from being permeated into the organic light emitting layer 130, the cathode electrode CE and the touch sensor electrode TSE. To this end, the encapsulation layer 150 may include at least one inorganic layer and at least one organic layer.

Meanwhile, although not shown in FIG. 5 and FIGS. 8A to 8C, a capping layer may additionally be provided between the second electrode 140 and the encapsulation layer 150.

A color filter CF may be provided over the encapsulation layer 150. The color filter CF may be provided over one surface of the second substrate 112 that faces the first substrate 111. In this case, the first substrate 111 provided with the encapsulation layer 150 and the second substrate 112 provided with the color filter CF may be bonded to each other by an adhesive layer 160. At this time, the adhesive layer 160 may be an optically clear resin (OCR) layer or an optically clear adhesive (OCA) film.

The color filter CF may be provided to be patterned for each of the subpixels SP1, SP2, SP3 and SP4. In detail, the color filter CF may include a first color filter, a second color filter, and a third color filter. The first color filter may be disposed to correspond to the light emission area EA1 of the first subpixel SP1, and may be a green color filter that transmits green light. The second color filter may be disposed to correspond to the light emission area EA2 of the second subpixel SP2, and may be a red color filter that transmits red light. The third color filter may be disposed to correspond to the light emission area EA3 of the third subpixel SP3, and may be a blue color filter that transmits blue light.

A black matrix BM may be provided between color filters CF. The black matrix BM may be disposed between the subpixels SP1, SP2, SP3 and SP4 to prevent a color mixture from occurring between adjacent subpixels SP1, SP2, SP3 and SP4. In addition, the black matrix BM may prevent light incident from the outside from being reflected by the plurality of lines provided between the subpixels SP1, SP2, SP3 and SP4.

In the transparent display panel 110 according to one embodiment of the present disclosure, the touch sensor electrode TSE of the touch sensor and the cathode electrode CE of the light emitting element may be formed in the same layer by the first undercut structure UC1. The transparent display panel 110 according to one embodiment of the present disclosure has a simple touch process and does not need to add a separate mask for the touch sensor electrode TSE.

Also, in the transparent display panel 110 according to one embodiment of the present disclosure, the first undercut structure UC1 may be formed using the planarization layer PLN and the plurality of inorganic insulating layers, whereby the first undercut structure UC1 may be formed without loss of light transmittance.

Also, in the transparent display panel 110 according to one embodiment of the present disclosure, the touch lines TL may be disposed below the light emitting element, whereby light emitting efficiency of the pixel P may be prevented from being deteriorated due to the touch lines TL.

Also, in the transparent display panel 110 according to one embodiment of the present disclosure, the touch lines TL may be disposed so as not to overlap the circuit areas CA1, CA2, CA3 and CA4, whereby the influence of the circuit elements may be reduced or minimized, and uniformity of parasitic capacitance may be improved.

Also, in the transparent display panel 110 according to one embodiment of the present disclosure, the plurality of touch lines TL may be disposed in the first non-transmissive area NTA1, and only one bridge line BL for connecting the plurality of touch sensors TS may be provided in the second non-transmissive area NTA2, whereby decrease in the size of the transmissive area TA or decrease in light transmittance due to the plurality of touch lines TL and the bridge line BL may be minimized.

In FIGS. 6 to 8C, the plurality of touch lines TL are shown as being disposed in the same layer as at least one of the first signal lines, but are not limited thereto.

In another embodiment, the plurality of touch lines TL may be disposed in a layer different from the first signal lines as shown in FIGS. 12 and 13. A first passivation layer PAS1 may be provided over the first signal lines. The plurality of touch lines TL may be provided over the first passivation layer PAS1, and a second passivation layer PAS2 may be disposed over the plurality of touch lines TL.

In the transparent display panel 110, the plurality of touch lines TL may be provided over the first passivation layer PAS1, and their horizontal distance and vertical distance with the first signal lines may be increased, whereby parasitic capacitance of the plurality of touch lines TL may be reduced.

Also, in the transparent display panel 110, the plurality of touch lines TL may be disposed over a different layer from the first signal lines, whereby spatial restriction caused by the first signal lines may be reduced in designing the plurality of touch lines TL. Therefore, the transparent display panel 110 may be designed such that there is no spaced distance difference between the plurality of touch lines TL, and may improve uniformity of parasitic capacitance between the plurality of touch lines TL.

According to the present disclosure, the following advantageous effects may be obtained.

In the present disclosure, the touch sensor electrode of the touch sensor and the cathode electrode of the light emitting element may be formed using the first undercut structure at the same time, whereby the touch process may be simplified, and a separate mask for the touch sensor electrode TSE is not required additionally.

Also, in the present disclosure, the first undercut structure may be formed using the planarization layer and the plurality of inorganic insulating layers, whereby loss of light transmittance may be avoided.

Also, in the present disclosure, the touch lines may be disposed so as not to overlap the circuit areas, whereby the influence of the circuit elements may be minimized, and at the same time uniformity of the parasitic capacitance may be improved.

It will be apparent to those skilled in the art that the present disclosure described above is not limited by the above-described embodiments and the accompanying drawings and that various substitutions, modifications and variations can be made in the present disclosure without departing from the scope of the disclosure. Consequently, the scope of the present disclosure is defined by the accompanying claims.

## Claims

1. A transparent display device comprising:
a substrate (111) provided with a plurality of transmissive areas (TA) and a non-transmissive area (NTA) including a plurality of light emission areas (EA) disposed between the transmissive areas (TA) adjacent to each other;
a plurality of light emitting elements over the substrate (111), each light emitting element provided in a respective one of the plurality of light emission areas (EA);
a plurality of touch sensors (TS) over the substrate (111), each touch sensor (TS) provided in a respective one of the plurality of transmissive areas (TA) and including a touch sensor electrode (TSE);
a plurality of touch lines (TL) provided in the non-transmissive area (NTA) over the substrate (111) and extended in a first direction;
a plurality of bridge lines (BL) provided in the non-transmissive area (NTA) over the substrate (111) and extended in a second direction to electrically connect the touch sensor electrodes (TSE) of at least two touch sensors (TS) disposed in the second direction with one of the plurality of touch lines (TL);
a touch contact portion (TCT) provided in a transmissive area (TA) of the plurality of transmissive areas (TA); and
a touch connection line (TCL) electrically connecting the touch contact portion (TCT) with a bridge line (BL) of the plurality of bridge lines (BL),
wherein the touch sensor electrode (TSE) is electrically connected to a touch line (TL) of the plurality of touch lines (TL) through the touch contact portion (TCT).

2. The transparent display device of claim 1, further comprising:
a first electrode (120) provided in each of the light emission areas (EA) over the substrate (111);
a light emitting layer (130) provided over the first electrode (120); and
a second electrode (140) disposed over the light emitting layer (130),
wherein the second electrode (140) includes a cathode electrode (CE) provided in the non-transmissive area (NTA) to constitute the light emitting elements in the non-transmissive area (NTA), and the touch sensor electrode (TSE) provided in a transmissive area (TA) of the plurality of transmissive areas (TA) to constitute the touch sensor (TS) in the transmissive area (TA).

3. The transparent display device of claim 2, further comprising a first undercut structure (UC1) disposed along an edge of the transmissive area (TA),
wherein the cathode electrode (CE) and the touch sensor electrode (TSE) are spaced apart from each other by the first undercut structure (UC1).

4. The transparent display device of claim 3, further comprising:
a plurality of inorganic insulating layers provided in the non-transmissive area (NTA) over the substrate (111) and made of an inorganic material; and
a planarization layer (PLN) provided in the non-transmissive area (NTA) over the plurality of inorganic insulating layers and made of an organic material,
wherein the first undercut structure (UC1) is provided such that the planarization layer (PLN) is more protruded toward the transmissive area (TA) than the plurality of inorganic insulating layers.

5. The transparent display device of any of claims 2 to 4, further comprising:
a common power line (VSS) provided in the non-transmissive area (NTA) over the substrate (111) and extended in the first direction;
a cathode contact portion (CCT) provided between the common power line (VSS) and the transmissive area (TA); and
a power connection line (VCL) electrically connecting the cathode contact portion (CCT) with the common power line (VSS),
wherein the cathode electrode (CE) is electrically connected to the common power line (VSS) through the cathode contact portion (CCT).

6. The transparent display device of claim 5, further comprising a second undercut structure (UC2) that exposes at least a portion of the cathode contact portion (CCT),
wherein the cathode electrode (CE) is directly in contact with the cathode contact portion (CCT) exposed by the second undercut structure (UC2).

7. The transparent display device of any of claims 1 to 6, further comprising a third undercut structure (UC3) that exposes at least a portion of the touch contact portion (TCT),
wherein the touch sensor electrode (TSE) is directly in contact with the touch contact portion (TCT) exposed by the third undercut structure (UC3).

8. The transparent display device of any of claims 1 to 7, wherein one bridge line (BL) of the plurality of bridge lines (BL) is connected to one of the plurality of touch lines (TL), and is connected to at least two touch connection lines (TCL) connected to each of at least two touch sensors (TS) disposed in the second direction.

9. The transparent display device of any of claims 1 to 8, further comprising:
a driving transistor (TFT) provided between the substrate (111) and the first electrode (120); and
a light shielding layer (LS) provided between the substrate (111) and the driving transistor (TFT),
wherein the touch connection line (TCL) is provided in the same layer as the light shielding layer (LS).

10. The transparent display device of any of claims 1 to 9, wherein the plurality of touch lines (TL) are provided to at least partially overlap the plurality of light emission areas (EA) between the substrate (111) and the first electrode (120).

11. The transparent display device of any of claims 1 to 10, further comprising:
a plurality of touch blocks (TB) including a plurality of pixels (P) provided in the non-transmissive area (NTA) and the plurality of touch sensors (TS) provided in the plurality of transmissive areas (TA); and
a touch driver (TIC), wherein the plurality of touch lines (TL) have one end connected to the touch driver (TIC).

12. The transparent display device of claim 11, wherein the number of the touch lines (TL) provided over the substrate (111) is a same as the number of touch blocks (TB) provided over the substrate (111).

13. The transparent display device of claim 11 or 12, wherein at least two touch lines (TL) are disposed between the transmissive areas (TA) adjacent to each other, and
one bridge line (BL) is disposed between the adjacent transmissive areas (TA).

14. The transparent display device of claim 3 or 4, wherein the first undercut structure (UC1) has a planar closed shape.

## Patentansprüche

1. Transparente Anzeigevorrichtung, aufweisend:
ein Substrat (111), das mit einer Mehrzahl von transmissiven Bereichen (TA) und einem nicht-transmissiven Bereich (NTA) bereitgestellt ist, der eine Mehrzahl von Lichtemissionsbereichen (EA) aufweist, die zwischen den zueinander benachbarten transmissiven Bereichen (TA) angeordnet ist,
eine Mehrzahl von lichtemittierenden Elementen über dem Substrat (111), wobei jedes lichtemittierende Element in einem jeweiligen aus der Mehrzahl von Lichtemissionsbereichen (EA) bereitgestellt ist,
eine Mehrzahl von Berührungssensoren (TS) über dem Substrat (111), wobei jeder Berührungssensor (TS) in einem jeweiligen aus der Mehrzahl von transmissiven Bereichen (TA) bereitgestellt ist und eine Berührungssensorelektrode (TSE) aufweist,
eine Mehrzahl von Berührungsleitungen (TL), die in dem nicht-transmissiven Bereich (NTA) über dem Substrat (111) bereitgestellt sind und sich in einer ersten Richtung erstrecken,
eine Mehrzahl von Brückenleitungen (BL), die in dem nicht-transmissiven Bereich (NTA) über dem Substrat (111) bereitgestellt sind und sich in einer zweiten Richtung erstrecken, um die Berührungssensorelektroden (TSE) von mindestens zwei Berührungssensoren (TS), die in der zweiten Richtung angeordnet sind, mit einer aus der Mehrzahl von Berührungsleitungen (TL) elektrisch zu verbinden,
einen Berührungskontaktabschnitt (TCT), der in einem transmissiven Bereich (TA) der Mehrzahl von transmissiven Bereichen (TA) bereitgestellt ist, und
eine Berührungsverbindungsleitung (TCL), die den Berührungskontaktabschnitt (TCT) mit einer Brückenleitung (BL) der Mehrzahl von Brückenleitungen (BL) elektrisch verbindet,
wobei die Berührungssensorelektrode (TSE) über den Berührungskontaktabschnitt (TCT) mit einer Berührungsleitung (TL) der Mehrzahl von Berührungsleitungen (TL) elektrisch verbunden ist.

2. Transparente Anzeigevorrichtung gemäß Anspruch 1, ferner aufweisend:
eine erste Elektrode (120), die in jedem der Lichtemissionsbereiche (EA) über dem Substrat (111) bereitgestellt ist,
eine lichtemittierende Schicht (130), die über der ersten Elektrode (120) bereitgestellt ist, und
eine zweite Elektrode (140), die über der lichtemittierenden Schicht (130) angeordnet ist,
wobei die zweite Elektrode (140) aufweist eine Kathodenelektrode (CE), die in dem nicht-transmissiven Bereich (NTA) bereitgestellt ist, um die lichtemittierenden Elemente in dem nicht-transmissiven Bereich (NTA) zu bilden, und die Berührungssensorelektrode (TSE), die in einem transmissiven Bereich (TA) der Mehrzahl von transmissiven Bereichen (TA) bereitgestellt ist, um den Berührungssensor (TS) in dem transmissiven Bereich (TA) zu bilden.

3. Transparente Anzeigevorrichtung gemäß Anspruch 2, ferner aufweisend eine erste Hinterschneidungsstruktur (UC1), die entlang eines Randes des transmissiven Bereichs (TA) angeordnet ist,
wobei die Kathodenelektrode (CE) und die Berührungssensorelektrode (TSE) durch die erste Hinterschneidungsstruktur (UC1) voneinander beabstandet sind.

4. Transparente Anzeigevorrichtung gemäß Anspruch 3, ferner aufweisend:
eine Mehrzahl von anorganischen Isolierschichten, die in dem nicht-transmissiven Bereich (NTA) über dem Substrat (111) bereitgestellt sind und aus einem anorganischen Material hergestellt sind, und
eine Planarisierungsschicht (PLN), die in dem nicht-transmissiven Bereich (NTA) über der Mehrzahl von anorganischen Isolierschichten bereitgestellt ist und aus einem organischen Material hergestellt ist,
wobei die erste Hinterschneidungsstruktur (UC1) so bereitgestellt ist, dass die Planarisierungsschicht (PLN) stärker in Richtung zu dem transmissiven Bereich (TA) als die Mehrzahl von anorganischen Isolierschichten hervorsteht.

5. Transparente Anzeigevorrichtung gemäß irgendeinem der Ansprüche 2 bis 4, ferner aufweisend:
eine gemeinsame Stromleitung (VSS), die in dem nicht-transmissiven Bereich (NTA) über dem Substrat (111) bereitgestellt ist und sich in der ersten Richtung erstreckt,
einen Kathodenkontaktabschnitt (CCT), der zwischen der gemeinsamen Stromleitung (VSS) und dem transmissiven Bereich (TA) bereitgestellt ist, und
eine Stromverbindungsleitung (VCL), die den Kathodenkontaktabschnitt (CCT) elektrisch mit der gemeinsamen Stromleitung (VSS) verbindet,
wobei die Kathodenelektrode (CE) über den Kathodenkontaktabschnitt (CCT) elektrisch mit der gemeinsamen Stromleitung (VSS) verbunden ist.

6. Transparente Anzeigevorrichtung gemäß Anspruch 5, ferner aufweisend eine zweite Hinterschneidungsstruktur (UC2), die mindestens einen Abschnitt des Kathodenkontaktabschnitts (CCT) freilegt,
wobei die Kathodenelektrode (CE) in direktem Kontakt mit dem durch die zweite Hinterschneidungsstruktur (UC2) freigelegten Kathodenkontaktabschnitt (CCT) ist.

7. Transparente Anzeigevorrichtung gemäß irgendeinem der Ansprüche 1 bis 6, ferner aufweisend eine dritte Hinterschneidungsstruktur (UC3), die mindestens einen Abschnitt des Berührungskontaktabschnitts (TCT) freilegt,
wobei die Berührungssensorelektrode (TSE) in direktem Kontakt mit dem durch die dritte Hinterschneidungsstruktur (UC3) freigelegten Berührungskontaktabschnitt (TCT) ist.

8. Transparente Anzeigevorrichtung gemäß irgendeinem der Ansprüche 1 bis 7, wobei eine Brückenleitung (BL) der Mehrzahl von Brückenleitungen (BL) mit einer aus der Mehrzahl von Berührungsleitungen (TL) verbunden ist und mit mindestens zwei Berührungsverbindungsleitungen (TCL) verbunden ist, die mit jedem von mindestens zwei Berührungssensoren (TS) verbunden sind, die in der zweiten Richtung angeordnet sind.

9. Transparente Anzeigevorrichtung gemäß irgendeinem der Ansprüche 1 bis 8, ferner aufweisend:
einen Ansteuertransistor (TFT), der zwischen dem Substrat (111) und der ersten Elektrode (120) bereitgestellt ist, und
eine Lichtabschirmschicht (LS), die zwischen dem Substrat (111) und dem Ansteuertransistor (TFT) bereitgestellt ist,
wobei die Berührungsverbindungsleitung (TCL) in der gleichen Schicht wie die Lichtabschirmschicht (LS) bereitgestellt ist.

10. Transparente Anzeigevorrichtung gemäß irgendeinem der Ansprüche 1 bis 9, wobei die Mehrzahl von Berührungsleitungen (TL) bereitgestellt sind, um die Mehrzahl von Lichtemissionsbereichen (EA) zwischen dem Substrat (111) und der ersten Elektrode (120) zumindest teilweise zu überlappen.

11. Transparente Anzeigevorrichtung gemäß irgendeinem der Ansprüche 1 bis 10, ferner aufweisend:
eine Mehrzahl von Berührungsblöcken (TB) aufweisend eine Mehrzahl von Pixeln (P), die in dem nicht-transmissiven Bereich (NTA) bereitgestellt sind, und die Mehrzahl von Berührungssensoren (TS), die in der Mehrzahl von transmissiven Bereichen (TA) bereitgestellt sind, und
einen Berührungstreiber (TIC), wobei die Mehrzahl von Berührungsleitungen (TL) ein Ende haben, das mit dem Berührungstreiber (TIC) verbunden ist.

12. Transparente Anzeigevorrichtung gemäß Anspruch 11, wobei die Anzahl der über dem Substrat (111) bereitgestellten Berührungsleitungen (TL) gleich der Anzahl von über dem Substrat (111) bereitgestellten Berührungsblöcken (TB) ist.

13. Transparente Anzeigevorrichtung gemäß Anspruch 11 oder 12, wobei mindestens zwei Berührungsleitungen (TL) zwischen den zueinander benachbarten transmissiven Bereichen (TA) angeordnet sind und
eine Brückenleitung (BL) zwischen den benachbarten transmissiven Bereichen (TA) angeordnet ist.

14. Transparente Anzeigevorrichtung gemäß Anspruch 3 oder 4, wobei die erste Hinterschneidungsstruktur (UC1) eine ebene, geschlossene Form hat.

## Revendications

1. Dispositif d'affichage transparent, comprenant :
un substrat (111) muni d'une pluralité de zones transmissives (TA) et d'une zone non transmissive (NTA) comprenant une pluralité de zones d'émission de lumière (EA) disposée entre les zones transmissives (TA) adjacentes les unes aux autres ;
une pluralité d'éléments électroluminescents sur le substrat (111), chaque élément électroluminescent étant prévu dans une zone respective parmi la pluralité de zones d'émission de lumière (EA) ;
une pluralité de capteurs tactiles (TS) sur le substrat (111), chaque capteur tactile (TS) étant prévu dans une zone respective parmi la pluralité de zones transmissives (TA) et comprenant une électrode de capteur tactile (TSE) ;
une pluralité de lignes tactiles (TL) prévues dans la zone non transmissive (NTA) sur le substrat (111) et s'étendant dans une première direction ;
une pluralité de lignes de pontage (BL) prévues dans la zone non transmissive (NTA) au-dessus du substrat (111) et s'étendant dans une deuxième direction pour connecter électriquement les électrodes de capteur tactile (TSE) d'au moins deux capteurs tactiles (TS) disposés dans la deuxième direction à l'une de la pluralité de lignes tactiles (TL) ;
une partie de contact tactile (TCT) prévue dans une zone transmissive (TA) parmi la pluralité de zones transmissives (TA) ; et
une ligne de connexion tactile (TCL) connectant électriquement la partie de contact tactile (TCT) à une ligne de pontage (BL) parmi la pluralité de lignes de pontage (BL),
dans lequel l'électrode de capteur tactile (TSE) est connectée électriquement à une ligne tactile (TL) parmi la pluralité de lignes tactiles (TL) par l'intermédiaire de la partie de contact tactile (TCT).

2. Dispositif d'affichage transparent selon la revendication 1, comprenant en outre :
une première électrode (120) prévue dans chacune des zones d'émission de lumière (EA) au-dessus du substrat (111) ;
une couche électroluminescente (130) prévue au-dessus de la première électrode (120) ; et
une deuxième électrode (140) disposée au-dessus de la couche électroluminescente (130),
dans lequel la deuxième électrode (140) comprend une électrode de cathode (CE) prévue dans la zone non transmissive (NTA) pour constituer les éléments électroluminescents dans la zone non transmissive (NTA), et l'électrode de capteur tactile (TSE) prévue dans une zone transmissive (TA) parmi la pluralité de zones transmissives (TA) pour constituer le capteur tactile (TS) dans la zone transmissive (TA).

3. Dispositif d'affichage transparent selon la revendication 2, comprenant en outre une première structure en contre-dépouille (UC1) disposée le long d'un bord de la zone transmissive (TA),
dans lequel l'électrode de cathode (CE) et l'électrode de capteur tactile (TSE) sont espacées l'une de l'autre par la première structure en contre-dépouille (UC1).

4. Dispositif d'affichage transparent selon la revendication 3, comprenant en outre :
une pluralité de couches isolantes inorganiques prévues dans la zone non transmissive (NTA) au-dessus du substrat (111) et constituées d'un matériau inorganique ; et
une couche de planarisation (PLN) prévue dans la zone non transmissive (NTA) au-dessus de la pluralité de couches isolantes inorganiques et constituée d'un matériau organique,
dans lequel la première structure en contre-dépouille (UC1) est prévue de telle sorte que la couche de planarisation (PLN) fait davantage saillie vers la zone transmissive (TA) que la pluralité de couches isolantes inorganiques.

5. Dispositif d'affichage transparent selon l'une quelconque des revendications 2 à 4, comprenant en outre :
une ligne d'alimentation commune (VSS) prévue dans la zone non transmissive (NTA) au-dessus du substrat (111) et s'étendant dans la première direction ;
une partie de contact de cathode (CCT) prévue entre la ligne d'alimentation commune (VSS) et la zone transmissive (TA) ; et
une ligne de connexion d'alimentation (VCL) connectant électriquement la partie de contact de cathode (CCT) à la ligne d'alimentation commune (VSS),
dans lequel l'électrode de cathode (CE) est connectée électriquement à la ligne d'alimentation commune (VSS) par l'intermédiaire de la partie de contact de cathode (CCT).

6. Dispositif d'affichage transparent selon la revendication 5, comprenant en outre une deuxième structure en contre-dépouille (UC2) qui expose au moins une partie de la partie de contact de cathode (CCT),
dans lequel l'électrode de cathode (CE) est directement en contact avec la partie de contact de cathode (CCT) exposée par la deuxième structure en contre-dépouille (UC2).

7. Dispositif d'affichage transparent selon l'une quelconque des revendications 1 à 6, comprenant en outre une troisième structure en contre-dépouille (UC3) qui expose au moins une partie de la partie de contact tactile (TCT),
dans lequel l'électrode de capteur tactile (TSE) est directement en contact avec la partie de contact tactile (TCT) exposée par la troisième structure en contre-dépouille (UC3).

8. Dispositif d'affichage transparent selon l'une quelconque des revendications 1 à 7, dans lequel une ligne de pontage (BL) parmi la pluralité de lignes de pontage (BL) est connectée à l'une parmi la pluralité de lignes tactiles (TL), et est connectée à au moins deux lignes de connexion tactiles (TCL) connectées à chacun d'au moins deux capteurs tactiles (TS) disposés dans la deuxième direction.

9. Dispositif d'affichage transparent selon l'une quelconque des revendications 1 à 8, comprenant en outre :
un transistor de commande (TFT) prévu entre le substrat (111) et la première électrode (120) ; et
une couche de protection contre la lumière (LS) prévue entre le substrat (111) et le transistor de commande (TFT),
dans lequel la ligne de connexion tactile (TCL) est prévue dans la même couche que la couche de protection contre la lumière (LS).

10. Dispositif d'affichage transparent selon l'une quelconque des revendications 1 à 9, dans lequel la pluralité de lignes tactiles (TL) sont prévues pour chevaucher au moins partiellement la pluralité de zones d'émission de lumière (EA) entre le substrat (111) et la première électrode (120).

11. Dispositif d'affichage transparent selon l'une quelconque des revendications 1 à 10, comprenant en outre :
une pluralité de blocs tactiles (TB) comprenant une pluralité de pixel (P) prévus dans la zone non transmissive (NTA) et la pluralité de capteurs tactiles (TS) prévus dans la pluralité de zones transmissives (TA) ; et
un pilote tactile (TIC), dans lequel la pluralité de lignes tactiles (TL) ont une extrémité connectée au pilote tactile (TIC).

12. Dispositif d'affichage transparent selon la revendication 11, dans lequel le nombre de lignes tactiles (TL) prévues sur le substrat (111) est identique au nombre de blocs tactiles (TB) prévus sur le substrat (111).

13. Dispositif d'affichage transparent selon la revendication 11 ou 12, dans lequel au moins deux lignes tactiles (TL) sont disposées entre les zones transmissives (TA) adjacentes les unes aux autres, et
une ligne de pontage (BL) est disposée entre les zones transmissives adjacentes (TA).

14. Dispositif d'affichage transparent selon la revendication 3 ou 4, dans lequel la première structure en contre-dépouille (UC1) a une forme plane fermée.
